(19) Europäisches Patentamt / European Patent Office / Office européen des brevets

(11) **EP 4 671 786 A1**

(12) **EUROPEAN PATENT APPLICATION**
published in accordance with Art. 153(4) EPC

(43) Date of publication:
**31.12.2025 Bulletin 2026/01**

(21) Application number: **24760428.3**

(22) Date of filing: **22.02.2024**

(51) International Patent Classification (IPC):
*G01R 31/367* (2019.01)     *G01R 31/3828* (2019.01)
*G01R 31/387* (2019.01)     *H01M 10/48* (2006.01)
*H02J 7/00* (2006.01)

(52) Cooperative Patent Classification (CPC):
**G01R 31/367; G01R 31/3828; G01R 31/387;
G01R 31/392; H01M 10/48; H02J 7/00;** Y02E 60/10

(86) International application number:
**PCT/JP2024/006454**

(87) International publication number:
**WO 2024/177130 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.02.2023 JP 2023026781**

(71) Applicant: **Eliiy Power Co., Ltd.
Tokyo 141-0032 (JP)**

(72) Inventor: **MIYAZAKI, Takahiro
Tokyo 141-0032 (JP)**

(74) Representative: **Strehl & Partner mbB
Maximilianstrasse 54
80538 München (DE)**

(54) **SECONDARY-BATTERY-UNIT CHARGING STATE ESTIMATION DEVICE,
SECONDARY-BATTERY-UNIT CHARGING STATE ESTIMATION METHOD, AND
SECONDARY-BATTERY-UNIT CHARGING STATE ESTIMATION PROGRAM**

(57)     A secondary battery unit charging state estimation device, a secondary battery unit charging state estimation method, and a secondary battery unit charging state estimation program, which can estimate the state of charge (SOC) of a secondary battery in real time with good followability based on parameters at the time of measurement, are provided.
The secondary battery unit charging state estimation device estimates, by employing the following formula 1 or 2, the state of charge (SOC) or the state of power (SOP) of a secondary battery unit having at least one battery cell. The secondary battery unit charging state estimation device is equipped with a corrected full charge capacity calculation means for calculating the corrected full charge capacity ($FCC_{adj}$) of the secondary battery unit. The corrected full charge capacity calculation means calculates the corrected full charge capacity ($FCC_{adj}$) by employing a Weibull function which uses, as variables, indices based on physical quantities at the time of measurement which are obtained from the secondary battery unit.
[Equation 1]

$$SOC = SOC_{last} + \sum_{k=1}^{n} \frac{i_k(t_k - t_{k-1})}{FCC_{adj}} \qquad (1)$$

[Equation 2]

$$SOP = SOP_{last} + \sum_{k=1}^{n} \frac{p_k(t_k - t_{k-1})}{FCC_{adj}} \qquad (2)$$

$i_k$: Charge/discharge current of the secondary battery unit, representing a current value of the charge/discharge current

EP 4 671 786 A1

being measured

$p_k$: Input/output power of the secondary battery unit, representing a power value of the input/output power

$t_k$: Usage time of the secondary battery unit

# FIG. 1

**Description**

[Technical Field]

This invention relates to a secondary battery unit charging state estimation device, a secondary battery unit charging state estimation method, and a secondary battery unit charging state estimation program.

[Background Art]

A secondary battery which can be charged and discharged repeatedly, such as a lithium ion battery, has hitherto been used in various machines, tools and devices. As an example of a technique for estimating the state of charge (SOC) of the secondary battery, there is a technique which, for example, integrates charged current and discharged current to estimate the state of charge, a so-called current integration method, as indicated by the following formula:

$$[\text{E q u a t i o n } 1]$$

$$SOC = SOC_{last} + \sum_{j=1}^{n} \frac{i_{j \times}(t_j - t_{j-1})}{FCC}$$

With this method, the state of charge can be determined in the following manner: The state of charge obtained last time is taken as a basis. The quantity of electric charge (Q) inputted to and outputted from the battery since last time until this time is divided by battery capacity when fully charged (namely, full charge capacity, FCC) to give the amount of change in electric charge as a result of charging and discharging. This amount of change is added to the above basic state of charge.

The state of charge (SOC) refers to a value obtained when the remaining amount of electricity stored in the secondary battery (namely, remaining capacity) is divided by full charge capacity, i.e. charge capacity at the time of full charging, and the value is expressed as percentage. This state of charge is 0% when the charge capacity of the secondary battery is zero, and 100% when the charge capacity of the secondary battery is equal to the full charge capacity.

So far, the state of charge has been estimated using a preset full charge capacity (fixed value).

However, the full charge capacity (FCC) used for the estimation of the state of charge is a value varying with the degradation or the like of the battery. Furthermore, the capacity actually charged to the battery may vary under an influence such as the temperature at the time of measurement or the magnitude of the current value.

To acquire the accurate state of charge, therefore, it is desirable to correct the quantity of electric charge inputted to and outputted from the battery, or the full charge capacity, in response to changes in various conditions.

In recent years, contrivances to estimate the full charge capacity as appropriate for more accurate estimation of the state of charge (SOC) have been adopted (see, for example, Patent Document 1).

Patent Document 1 indicated above discloses a configuration equipped with an SOC determination unit for determining which of the full charge capacity or dischargeable capacity of a battery is based in estimating the state of charge of the battery; a full charge capacity estimation unit for estimating the full charge capacity; a discharge capacity estimation unit for estimating a dischargeable capacity; and a current integration estimation unit for estimating the state of charge of the battery based on the full charge capacity or the dischargeable capacity. Patent Document 1 also describes that the full charge capacity estimation unit estimates the full charge capacity based on the value of change in the charge amount during a predetermined period, and the current integration value during the predetermined period required for the change.

Besides, the patent document describes a method for making corrections to charge-discharge section capacity corresponding to the quantity of electricity during charging and discharging with the use of a table of preset correction factors to estimate the full charge capacity.

Moreover, the patent document describes a method for correcting the full charge capacity by use of a map relying on the discharge rate and the degree of deterioration.

[Prior Art Documents]

[Patent Documents]

[Patent Document 1] WO 2016/129212

[Summary of the Invention]

[Problems to be solved by the invention]

A full charge capacity used for estimation of a state of charge (SOC) is estimated and varied as appropriate, whereby it becomes possible to improve the estimation accuracy of the state of charge. The method as described in Patent Document 1, however, poses the problem that the estimated state of charge deviates owing to a current value, temperature, etc. at the time of SOC estimation. This method also involves the problem that if a more accurate estimation is to be made, tables of correction factors, correction maps, etc. should be provided in large numbers, resulting in huge data amounts.

The present invention has been accomplished in the light of the above-mentioned circumstances. It is an object of this invention to provide a secondary battery unit charging state estimation device, a secondary battery unit charging state estimation method, and a secondary battery unit charging state estimation program, which can estimate the state of charge (SOC) of a secondary battery in real time with good followability based on parameters at the time of measurement.

[Means for Solving the Problems]

A first aspect of the present invention, designed to solve the above-mentioned problems, resides in a secondary battery unit charging state estimation device which estimates, by employing the following formula 1 or 2, the state of charge (SOC) or the state of power (SOP) of a secondary battery unit having at least one battery cell, wherein the secondary battery unit charging state estimation device is equipped with a corrected full charge capacity calculation means for calculating the corrected full charge capacity ($FCC_{adj}$) of the secondary battery unit, and the corrected full charge capacity calculation means calculates the corrected full charge capacity ($FCC_{adj}$) by employing a Weibull function which uses, as variables, indices based on physical quantities at the time of measurement which are obtained from the secondary battery unit.

[Equation 2]

$$SOC = SOC_{last} + \sum_{k=1}^{n} \frac{i_k(t_k - t_{k-1})}{FCC_{adj}} \qquad (1)$$

[Equation 3]

$$SOP = SOP_{last} + \sum_{k=1}^{n} \frac{p_k(t_k - t_{k-1})}{FCC_{adj}} \qquad (2)$$

$i_k$: Charge/discharge current of the secondary battery unit, representing the current value of the charge/discharge current being measured
$p_k$: Input/output power of the secondary battery unit, representing the power value of the input and output power
$t_k$: Usage time of the secondary battery unit

A second aspect of the present invention resides in the secondary battery unit charging state estimation device according to the first aspect, wherein the corrected full charge capacity calculation means has a first correction factor calculation means, the first correction factor calculation means calculates a first correction factor which is obtained from a first function, including a Weibull function, using as a variable at least one of the following four indices, and the corrected full charge capacity calculation means corrects an initial full charge capacity (FCC) by use of the first correction factor to calculate the corrected full charge capacity ($FCC_{adj}$):

First index: First index (I) based on a current value ($i_j$) of the charge/discharge current of the secondary battery unit which is the charge/discharge current at the time of measurement
Second index: Second index (P) based on a power value ($p_j$) of the input/output power of the secondary battery unit which is the input/output power at the time of measurement
Third index: Third index (T) based on a temperature ($Temp_j$), at the time of measurement, of the secondary battery unit
Fourth index: Fourth index (S) based on a state of health ($SOH_j$), at the time of measurement, of the secondary battery unit.

A third aspect of the present invention resides in the secondary battery unit charging state estimation device according to the second aspect, wherein the corrected full charge capacity calculation means selects a plurality of any functions from among the Weibull function using the first index (I) or the second index (P) as the variable, the Weibull function using the third index (T) as the variable, and the Weibull function using the fourth index (S) as the variable, and performs predetermined four arithmetic operations of the plurality of functions to calculate the first correction factor.

A fourth aspect of the present invention resides in the secondary battery unit charging state estimation device according to the first aspect, wherein the corrected full charge capacity calculation means has a second correction factor calculation means, and the second correction factor calculation means calculates a second correction factor which is obtained from the Weibull function using as the variable an index (T) based on the temperature, at the time of measurement, of the secondary battery unit, and the corrected full charge capacity calculation means corrects an initial full charge capacity (FCC) by use of the second correction factor to calculate the corrected full charge capacity (FCC$_{adj}$).

A fifth aspect of the present invention resides in the secondary battery unit charging state estimation device according to the fourth aspect, wherein the second correction factor calculation means calculates the second correction factor to be obtained from the following formula 3 which uses, as the variables, the temperature (Temp$_j$), at the time of measurement, of the secondary battery unit, and coefficients provided beforehand which are derived from a relationship between the temperature of the secondary unit and an initial battery capacity of the battery unit.

[Equation 4]

$$\text{Second correction factor} = \exp\left\{-\left(Temp_j / \eta_{std\_T}\right)^{m_{std\_T}}\right\} \quad (3)$$

$\eta_{std\_T}$, $m_{std\_T}$: Coefficients derived from the relationship between the temperature of the secondary battery unit and the initial battery capacity of the battery unit

A sixth aspect of the present invention resides in the secondary battery unit charging state estimation device according to the second aspect, wherein the corrected full charge capacity calculation means has the first correction factor calculation means and a second correction factor calculation means, the second correction factor calculation means calculates a second correction factor to be obtained from the Weibull function which uses, as the variable, the temperature (Temp$_j$), at the time of measurement, of the secondary battery unit, and the corrected full charge capacity calculation means corrects the initial full charge capacity (FCC) by use of the first correction factor and the second correction factor to calculate the corrected full charge capacity (FCC$_{adj}$).

A seventh aspect of the present invention resides in the secondary battery unit charging state estimation device according to the third aspect, wherein the corrected full charge capacity calculation means has the first correction factor calculation means and a second correction factor calculation means, the second correction factor calculation means calculates a second correction factor to be obtained from the Weibull function which uses, as the variable, the temperature (Temp$_j$), at the time of measurement, of the secondary battery unit, and the corrected full charge capacity calculation means corrects the initial full charge capacity (FCC) by use of the first correction factor and the second correction factor to calculate the corrected full charge capacity (FCC$_{adj}$).

An eighth aspect of the present invention resides in the secondary battery unit charging state estimation device according to the seventh aspect, wherein the second correction factor calculation means calculates the second correction factor to be obtained from the following formula 3 which uses, as the variables, the temperature (Temp$_j$), at the time of measurement, of the secondary battery unit, and coefficients provided beforehand which are derived from a relationship between the temperature of the secondary battery unit and an initial battery capacity of the battery unit.

[Equation 5]

$$\text{Second correction factor} = \exp\left\{-\left(Temp_j / \eta_{std\_T}\right)^{m_{std\_T}}\right\} \quad (3)$$

$\eta_{std\_T}$, $m_{std\_T}$: Coefficients provided beforehand which are derived from the relationship between the temperature of the secondary battery unit and the initial battery capacity of the battery unit

A ninth aspect of the present invention resides in the secondary battery unit charging state estimation device according to the eighth aspect, wherein the corrected full charge capacity calculation means corrects the initial full charge capacity (FCC) by use of the first correction factor which is obtained from the following formula 4 and formula 5 to calculate the corrected full charge capacity (FCC$_{adj}$):

[Equation 6]

$$\text{First correction factor} = \exp\left\{-\left(\frac{x(1)}{\eta}\right)^m\right\} \times x(3) \quad (4)$$

[Equation 7]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (5)$$

For $\chi(1)$, $x(2)$ and $\chi(3)$, any indices among the first index (I), the second index (P), the third index (T), and the fourth index (S) are set so as not to overlap.

Formula 5 is a fitting formula for determining m and $\eta$, and prm(1), prm(2), prm(3), and prm(4) represent any numbers to be obtained by fitting.

A tenth aspect of the present invention resides in the secondary battery unit charging state estimation device according to the eighth aspect, wherein the corrected full charge capacity calculation means corrects the initial full charge capacity (FCC) by use of the first correction factor which is obtained from the following formula 6 and formula 7 to calculate the corrected full charge capacity (FCC$_{adj}$):

[Equation 8]

$$\text{First correction factor} = \exp\left\{-\left(\frac{x(1)}{\eta}\right)^m\right\} \times x(3) \quad (6)$$

[Equation 9]

$$\begin{bmatrix} m \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \quad (7)$$

For $\chi(1)$, $x(2)$ and $\chi(3)$, any indices among the first index (I), the second index (P), the third index (T), and the fourth index (S) are set so as not to overlap.

Formula 7 is a fitting formula for determining m and $\eta$, and prm(1), prm(2), prm(3), and prm(4) represent any numbers to be obtained by fitting.

An eleventh aspect of the present invention resides in the secondary battery unit charging state estimation device according to the eighth aspect, wherein the corrected full charge capacity calculation means corrects the initial full charge capacity (FCC) by use of the first correction factor which is obtained from the following formula 8 and formula 9 to calculate the corrected full charge capacity (FCC$_{adj}$):

[Equation 10]

$$\text{First correction factor} = \exp\left\{-\left(\frac{x(1)}{\eta}\right)^m\right\} \times x(3) \quad (8)$$

[Equation 11]

$$\begin{bmatrix} ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \quad (9)$$

For $\chi(1)$, $x(2)$ and $\chi(3)$, any indices among the first index (I), the second index (P), the third index (T), and the fourth index (S) are set so as not to overlap.

Formula 9 is a fitting formula for determining m and $\eta$, and prm(1), prm(2), prm(3), and prm(4) represent any numbers to be obtained by fitting.

A twelfth aspect of the present invention resides in a secondary battery unit charging state estimation method which estimates, by employing the following formula 1 or 2, the state of charge (SOC) or the state of power (SOP) of a secondary battery unit having at least one battery cell,
the method comprising:

calculating a corrected full charge capacity (FCC$_{adj}$) of the secondary battery unit; and
calculating the corrected full charge capacity (FCC$_{adj}$) by employing a Weibull function which uses, as variables, indices based on physical quantities at the time of measurement which are obtained from the secondary battery unit.
[Equation 12]

$$SOC = SOC_{last} + \sum_{k=1}^{n} \frac{i_k(t_k - t_{k-1})}{FCC_{adj}} \qquad (1)$$

[Equation 13]

$$SOP = SOP_{last} + \sum_{k=1}^{n} \frac{p_k(t_k - t_{k-1})}{FCC_{adj}} \qquad (2)$$

$i_k$: Charge/discharge current of the secondary battery unit, representing the current value of the charge/discharge current being measured

$p_k$: Input/output power of the secondary battery unit, representing the power value of the input/output power

$t_k$: Usage time of the secondary battery unit

A thirteenth aspect of the present invention resides in the secondary battery unit charging state estimation method according to the twelfth aspect, comprising:

calculating a first correction factor which is obtained from a first function, including a Weibull function, using as a variable at least one of the following four indices; and

correcting an initial full charge capacity (FCC) by use of the first correction factor to calculate the corrected full charge capacity ($FCC_{adj}$):

First index: First index (I) based on the current value ($i_j$) of the charge/discharge current of the secondary battery unit which is the charge/discharge current at the time of measurement

Second index: Second index (P) based on the power value ($p_j$) of the input/output power of the secondary battery unit which is the input/output power at the time of measurement

Third index: Third index (T) based on the temperature ($Temp_j$), at the time of measurement, of the secondary battery unit

Fourth index: Fourth index (S) based on the state of health ($SOH_j$), at the time of measurement, of the secondary battery unit.

A fourteenth aspect of the present invention resides in the secondary battery unit charging state estimation method according to the thirteenth aspect, comprising:

selecting a plurality of any functions from among the Weibull function using the first index (I) or the second index (P) as the variable, the Weibull function using the third index (T) as the variable, and the Weibull function using the fourth index (S) as the variable; and

performing predetermined four arithmetic operations of the plurality of functions to calculate the first correction factor.

A fifteenth aspect of the present invention resides in the secondary battery unit charging state estimation method according to the twelfth aspect, comprising:

calculating a second correction factor which is obtained from the Weibull function using as the variable an index (T) based on the temperature, at the time of measurement, of the secondary battery unit; and

correcting an initial full charge capacity (FCC) by use of the second correction factor to calculate the corrected full charge capacity ($FCC_{adj}$).

A sixteenth aspect of the present invention resides in the secondary battery unit charging state estimation method according to the fifteenth aspect, comprising:

calculating the second correction factor to be obtained from the following formula 3 which uses, as the variables, the temperature ($Temp_j$), at the time of measurement, of the secondary battery unit, and coefficients provided beforehand which are derived from a relationship between the temperature of the secondary battery unit and the initial battery capacity of the battery unit.

[Equation 14]

$$\text{Second correction factor} = \exp\left\{-\left(Temp_j / \eta_{std\_T}\right)^{m_{std\_T}}\right\} \qquad (3)$$

$\eta_{std\_T}$, $m_{std\_T}$: Coefficients derived from the relationship between the temperature of the secondary battery unit and the initial battery capacity of the battery unit

A seventeenth aspect of the present invention resides in the secondary battery unit charging state estimation method according to the thirteenth aspect, comprising:

calculating a second correction factor to be obtained from the Weibull function which uses, as the variable, the temperature ($Temp_j$), at the time of measurement, of the secondary battery unit; and
correcting the initial full charge capacity (FCC) by use of the first correction factor and the second correction factor to calculate the corrected full charge capacity ($FCC_{adj}$).

An eighteenth aspect of the present invention resides in the secondary battery unit charging state estimation method according to the fourteenth aspect, comprising:

calculating a second correction factor to be obtained from the Weibull function which uses, as the variable, the temperature ($Temp_j$), at the time of measurement, of the secondary battery unit; and
correcting the initial full charge capacity (FCC) by use of the first correction factor and the second correction factor to calculate the corrected full charge capacity ($FCC_{adj}$).

A nineteenth aspect of the present invention resides in the secondary battery unit charging state estimation method according to the eighteenth aspect, comprising:
calculating the second correction factor to be obtained from the following formula 3 which uses, as the variables, the temperature ($Temp_j$), at the time of measurement, of the secondary battery unit, and coefficients provided beforehand which are derived from a relationship between the temperature of the secondary battery unit and the initial battery capacity of the battery unit.
[Equation 15]

$$\text{Second correction factor} = \exp\left\{-\left(Temp_j/\eta_{std\_T}\right)^{m_{std\_T}}\right\} \qquad (3)$$

$\eta_{std\_T}$, $m_{std\_T}$: Coefficients provided beforehand which are derived from the relationship between the temperature of the secondary battery unit and the initial battery capacity of the battery unit

A twentieth aspect of the present invention resides in the secondary battery unit charging state estimation method according to the nineteenth aspect, comprising:
correcting the initial full charge capacity (FCC) by use of the first correction factor which is obtained from the following formula 4 and formula 5 to calculate the corrected full charge capacity ($FCC_{adj}$):
[Equation 16]

$$\text{First correction factor} = \exp\left\{-\left(\frac{x(1)}{\eta}\right)^{m}\right\} \times x(3) \qquad (4)$$

[Equation 17]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \qquad (5)$$

For $\chi(1)$, $x(2)$ and $\chi(3)$, any indices among the first index (I), the second index (P), the third index (T), and the fourth index (S) are set so as not to overlap.

Formula 5 is a fitting formula for determining m and $\eta$, and prm(1), prm(2), prm(3), and prm(4) represent any numbers to be obtained by fitting.

A twenty-first aspect of the present invention resides in the secondary battery unit charging state estimation method according to the nineteenth aspect, comprising:
correcting the initial full charge capacity (FCC) by use of the first correction factor which is obtained from the following formula 6 and formula 7 to calculate the corrected full charge capacity ($FCC_{adj}$):
[Equation 18]

8

$$\text{First correction factor} = \exp\left\{-\left(\frac{x(1)}{\eta}\right)^{m}\right\} \times x(3) \qquad (6)$$

[Equation 19]

$$\begin{bmatrix} m \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (7)$$

For $\chi(1)$, $x(2)$ and $\chi(3)$, any indices among the first index (I), the second index (P), the third index (T), and the fourth index (S) are set so as not to overlap.

Formula 7 is a fitting formula for determining m and $\eta$, and prm(1), prm(2), prm(3), and prm(4) represent any numbers to be obtained by fitting.

A twenty-second aspect of the present invention resides in the secondary battery unit charging state estimation method according to the nineteenth aspect, comprising:

correcting the initial full charge capacity (FCC) by use of the first correction factor which is obtained from the following formula 8 and formula 9 to calculate the corrected full charge capacity (FCC$_{adj}$):

[Equation 20]

$$\text{First correction factor} = \exp\left\{-\left(\frac{x(1)}{\eta}\right)^{m}\right\} \times x(3) \qquad (8)$$

[Equation 21]

$$\begin{bmatrix} ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (9)$$

For $\chi(1)$, $x(2)$ and $\chi(3)$, any indices among the first index (I), the second index (P), the third index (T), and the fourth index (S) are set so as not to overlap.

Formula 9 is a fitting formula for determining m and $\eta$, and prm(1), prm(2), prm(3), and prm(4) represent any numbers to be obtained by fitting.

A twenty-third aspect of the present invention resides in a secondary battery unit charging state estimation program which estimates, by employing the following formula 1 or formula 2, the state of charge (SOC) or the state of power (SOP) of a secondary battery unit having at least one battery cell,

the program comprising making a computer function to execute a procedure of:

calculating a corrected full charge capacity (FCC$_{adj}$) by employing a Weibull function which uses, as variables, indices based on physical quantities at the time of measurement which are obtained from the secondary battery unit.

[Equation 22]

$$SOC = SOC_{last} + \sum_{k=1}^{n} \frac{i_k(t_k - t_{k-1})}{FCC_{adj}} \qquad (1)$$

[Equation 23]

$$SOP = SOP_{last} + \sum_{k=1}^{n} \frac{p_k(t_k - t_{k-1})}{FCC_{adj}} \qquad (2)$$

$i_k$: Charge/discharge current of the secondary battery unit, representing a current value of the charge/discharge current being measured

$p_k$: Input/output power of the secondary battery unit, representing a power value of the input/output power

$t_k$: Usage time of the secondary battery unit

A twenty-fourth aspect of the present invention resides in the secondary battery unit charging state estimation program according to the twenty-third aspect,

the program comprising making a computer function to execute a procedure of:

calculating a first correction factor which is obtained from a first function, including a Weibull function, using as a variable at least one of the following four indices; and

correcting an initial full charge capacity (FCC) by use of the first correction factor to calculate the corrected full charge capacity (FCC$_{adj}$):

First index: First index (I) based on the current value ($I_j$) of the charge/discharge current of the secondary battery unit which is the charge/discharge current at the time of measurement

Second index: Second index (P) based on the power value ($P_j$) of the input/output power of the secondary battery unit which is the input/output power at the time of measurement

Third index: Third index (T) based on the temperature (Temp$_j$), at the time of measurement, of the secondary battery unit

Fourth index: Fourth index (S) based on the state of health (SOH$_j$), at the time of measurement, of the secondary battery unit.

A twenty-fifth aspect of the present invention resides in the secondary battery unit charging state estimation program according to the twenty-fourth aspect,
the program comprising making a computer function to execute a procedure of:

selecting a plurality of any functions from among the Weibull function using the first index (I) or the second index (P) as the variable, the Weibull function using the third index (T) as the variable, and the Weibull function using the fourth index (S) as the variable; and

performing predetermined four arithmetic operations of the plurality of functions to calculate the first correction factor.

A twenty-sixth aspect of the present invention resides in the secondary battery unit charging state estimation program according to the twenty-third aspect,
the program comprising making a computer function to execute a procedure of:

calculating a second correction factor which is obtained from the Weibull function using as the variable an index (T) based on the temperature, at the time of measurement, of the secondary battery unit; and

correcting an initial full charge capacity (FCC) by use of the second correction factor to calculate the corrected full charge capacity (FCC$_{adj}$).

A twenty-seventh aspect of the present invention resides in the secondary battery unit charging state estimation program according to the twenty-sixth aspect,
the program comprising making a computer function to execute a procedure of:
calculating the second correction factor to be obtained from the following formula 3 which uses, as variables, the temperature (Temp$_j$), at the time of measurement, of the secondary battery unit, and coefficients provided beforehand which are derived from a relationship between the temperature of the secondary battery unit and the initial battery capacity of the battery unit.
[Equation 24]

$$\text{Second correction factor} = \exp\left\{-\left(Temp_j / \eta_{std\_T}\right)^{m_{std\_T}}\right\} \quad (3)$$

$\eta_{std\_T}$, $m_{std\_T}$: Coefficients derived from the relationship between the temperature of the secondary battery unit and the initial battery capacity of the battery unit

A twenty-eighth aspect of the present invention resides in the secondary battery unit charging state estimation program according to the twenty-fourth aspect,
the program comprising making a computer function to execute a procedure of:

calculating a second correction factor to be obtained from the Weibull function which uses, as the variable, the temperature (Temp$_j$), at the time of measurement, of the secondary battery unit; and

correcting the initial full charge capacity (FCC) by use of the first correction factor and the second correction factor to calculate the corrected full charge capacity (FCC$_{adj}$).

A twenty-ninth aspect of the present invention resides in the secondary battery unit charging state estimation program according to the twenty-fifth aspect,
the program comprising making a computer function to execute a procedure of:

calculating a second correction factor to be obtained from the Weibull function which uses, as the variable, the temperature ($Temp_j$), at the time of measurement, of the secondary battery unit; and
correcting the initial full charge capacity (FCC) by use of the first correction factor and the second correction factor to calculate the corrected full charge capacity ($FCC_{adj}$).

A thirtieth aspect of the present invention resides in the secondary battery unit charging state estimation program according to the twenty-ninth aspect,
the program comprising making a computer function to execute a procedure of:
calculating the second correction factor to be obtained from the following formula 3 which uses, as variables, the temperature ($Temp_j$), at the time of measurement, of the secondary battery unit, and coefficients provided beforehand which are derived from a relationship between the temperature of the secondary battery unit and the initial battery capacity of the battery unit.
[Equation 25]

$$\text{Second correction factor} = \exp\left\{-\left(Temp_j/\eta_{std\_T}\right)^{m_{std\_T}}\right\} \quad (3)$$

$\eta_{std\_T}$, $m_{std\_T}$: Coefficients provided beforehand which are derived from the relationship between the temperature of the secondary battery unit and the initial battery capacity of the battery unit

A thirty-first aspect of the present invention resides in the secondary battery unit charging state estimation program according to the thirtieth aspect,
the program comprising making a computer function to execute a procedure of:
correcting the initial full charge capacity (FCC) by use of the first correction factor which is obtained from the following formula 4 and formula 5 to calculate the corrected full charge capacity ($FCC_{adj}$):
[Equation 26]

$$\text{First correction factor} = \exp\left\{-\left(\frac{x(1)}{\eta}\right)^{m}\right\} \times x(3) \quad (4)$$

[Equation 27]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (5)$$

For $x(1)$, $x(2)$ and $x(3)$, any indices among the first index (I), the second index (P), the third index (T), and the fourth index (S) are set so as not to overlap.
Formula 5 is a fitting formula for determining m and $\eta$, and prm(1), prm(2), prm(3), and prm(4) represent any numbers to be obtained by fitting.
A thirty-second aspect of the present invention resides in the secondary battery unit charging state estimation program according to the thirtieth aspect,
the program comprising making a computer function to execute a procedure of:
correcting the initial full charge capacity (FCC) by use of the first correction factor which is obtained from the following formula 6 and formula 7 to calculate the corrected full charge capacity ($FCC_{adj}$):
[Equation 28]

$$\text{First correction factor} = \exp\left\{-\left(\frac{x(1)}{\eta}\right)^{m}\right\} \times x(3) \quad (6)$$

[Equation 29]

$$\begin{bmatrix} m \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \quad (7)$$

For $\chi(1)$, $x(2)$ and $\chi(3)$, any indices among the first index (I), the second index (P), the third index (T), and the fourth index (S) are set so as not to overlap.

Formula 7 is a fitting formula for determining m and $\eta$, and prm(1), prm(2), prm(3), and prm(4) represent any numbers to be obtained by fitting.

A thirty-third aspect of the present invention resides in the secondary battery unit charging state estimation program according to the thirtieth aspect,

the program comprising making a computer function to execute a procedure of:

correcting the initial full charge capacity (FCC) by use of the first correction factor which is obtained from the following formula 8 and formula 9 to calculate the corrected full charge capacity ($FCC_{adj}$):

[Equation 30]

$$\text{First correction factor} = \exp\left\{-\left(\frac{x(1)}{\eta}\right)^m\right\} \times x(3) \quad (8)$$

[Equation 31]

$$\begin{bmatrix} ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \quad (9)$$

For $\chi(1)$, $x(2)$ and $\chi(3)$, any indices among the first index (I), the second index (P), the third index (T), and the fourth index (S) are set so as not to overlap.

Formula 9 is a fitting formula for determining m and $\eta$, and prm(1), prm(2), prm(3), and prm(4) represent any numbers to be obtained by fitting.

[Effects of the Invention]

According to the present invention, the state of charge (SOC) of a secondary battery unit can be estimated in real time with good followability based on parameters at the time of measurements. Furthermore, this invention enables the intended object to be attained using predetermined calculation formulas. Thus, tables of correction factors, correction maps, etc., which should be stored in the system, can be decreased in amount, so that the load on the system can be reduced.

[Brief Description of the Drawings]

[Fig. 1] is a functional block diagram showing an example of a control unit of a storage battery system.

[Fig. 2] is a view illustrating the method of the present invention, which shows the relation between a temperature and an FCC ratio.

[Fig. 3] is a view illustrating the method of the present invention, which shows a prediction line by Weibull plotting using records of measured data.

[Fig. 4] is a view showing the relationship between the SOC and current values of a secondary battery unit in Test Example 1.

[Fig. 5] is a view showing changes in the current values of the secondary battery unit in Test Example 1.

[Fig. 6] is a view showing the relationship between the SOC and voltage values of the secondary battery unit in Test Example 1.

[Fig. 7] is a view showing the relationship between the SOC and the voltage values of the secondary battery unit in Test Example 1.

[Fig. 8] is a view showing the relationship between the SOC and the voltage values of the secondary battery unit in Test Example 1.

[Fig. 9] is a view showing the relationship between the SOC and current values of a secondary battery unit in Test Example 2.

[Fig. 10] is a view showing changes in the current values of the secondary battery unit in Test Example 2.

[Fig. 11] is a view showing the relationship between the SOC and voltage values of the secondary battery unit in Test Example 2.

[Fig. 12] is a view showing the relationship between the SOC and the voltage values of the secondary battery unit in Test Example 2.

[Fig. 13] is a view showing the relationship between the SOC and the voltage values of the secondary battery unit in Test Example 2.

[Fig. 14] is a view showing the relationship between the SOC and current values of a secondary battery unit in Test Example 3.

[Fig. 15] is a view showing changes in the current values of the secondary battery unit in Test Example 3.

[Fig. 16] is a view showing the relationship between the SOC and voltage values of the secondary battery unit in Test Example 3.

[Fig. 17] is a view showing the relationship between the SOC and the voltage values of the secondary battery unit in Test Example 3.

[Fig. 18] is a view showing the relationship between the SOC and the voltage values of the secondary battery unit in Test Example 3.

[Fig. 19] is a view showing the relationship between the SOC and current values of a secondary battery unit in Test Example 4.

[Fig. 20] is a view showing changes in the current values of the secondary battery unit in Test Example 4.

[Fig. 21] is a view showing the relationship between the SOC and voltage values of the secondary battery unit in Test Example 4.

[Fig. 22] is a view showing the relationship between the SOC and the voltage values of the secondary battery unit in Test Example 4.

[Fig. 23] is a view showing the relationship between the SOC and the voltage values of the secondary battery unit in Test Example 4.

[Mode for Carrying Out the Invention]

An embodiment of the present invention will be described in detail below.

A secondary battery unit, a subject of the present invention, has a single battery cell or a plurality of battery cells configured to be capable of charging and discharging power. As the secondary battery unit, a lithium ion battery, a nickel-metal hydride battery, a nickelcadmium battery, or a lead-acid battery, for example, can be used. The plurality of battery cells are connected based on functions and capabilities required of a storage battery, and may be connected in series or in parallel.

A power regulator of a storage battery system as mentioned above has a control unit exercise such control as to convert direct current power, which has been generated by a power generation device, to alternating current via the secondary battery unit and an inverter and supply it to a load at a desired timing in a desired proportion. The power regulator also has the control unit exercise such control as to convert alternating current power, which has been supplied from a commercial power source, to direct current via the load and the inverter and supply it to the secondary battery unit at a desired timing.

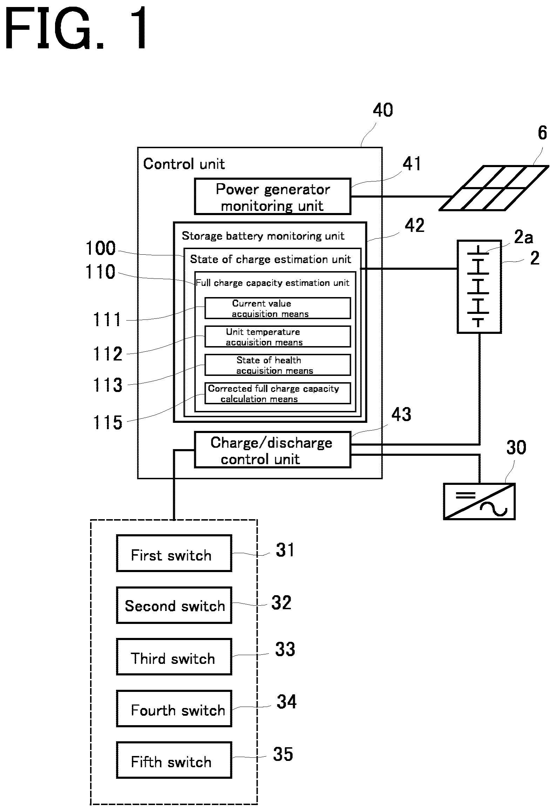

Here, an example of the control unit of the power regulator will be described by reference to Fig. 1. Fig. 1 is a functional block diagram showing the schematic configuration of a control unit 40.

As shown in Fig. 1, the control unit 40 controls the whole of the power regulator, and is equipped with a power generator monitoring unit 41, a storage battery monitoring unit 42, and a charge/discharge control unit 43.

The storage battery monitoring unit 42 measures the charge/discharge current value and voltage value of a secondary battery unit 2, battery temperature which is the temperature of the secondary battery unit 2, and the operating time of the secondary battery unit 2. The charge/discharge current value includes a charge current value which is the current value of the secondary battery unit 2 when charged, and a discharge current value which is the current value of the secondary battery unit 2 when discharged.

The storage battery monitoring unit 42 may function as a monitor for monitoring the voltage value, current value, battery temperature, etc. of each battery cell 2a or each battery cell group composed of the plurality of battery cells 2a (i.e., CMU: Cell Monitor Unit). The storage battery monitoring unit 42 senses an abnormality in the charge/discharge current value, voltage value, battery temperature, etc. of the battery cell 2a or the group of the plurality of battery cells, and communicates the occurrence of the abnormality to the charge/discharge control unit 43.

The current value of the secondary battery unit 2 to be measured may be the current value of the battery assembly, or may be the current value of the single battery. According to the size of the system or the purpose of measurement, the subject to be measured can be selected as appropriate.

The temperature of the secondary battery unit 2 to be measured may be the temperature of the battery assembly, or may be the temperature of the single battery. According to the size of the system or the purpose of measurement, the subject to be measured can be selected as appropriate.

Based on the results of the above measurement, etc., the storage battery monitoring unit 42 estimates the state of charge (SOC), the state of power (SOP), etc. of the secondary battery unit 2. In the present embodiment, for example, the storage battery monitoring unit 42 has a state of charge estimation unit 100 as a state of charge estimation device. As will be described in detail later, the state of charge estimation unit 100 estimates the corrected full charge capacity ($FCC_{adj}$) and the state of charge (SOC) of the secondary battery unit 2 at predetermined intervals. Moreover, the storage battery monitoring unit 42 estimates the state of health (SOH) of the secondary battery unit 2 at the same timing as that for the state of charge (SOC).

The power generator monitoring unit 41, the storage battery monitoring unit 42, and the charge/discharge control unit 43 described above can be realized by a central processor (CPU: Central Processing Unit) constituting the power regulator 3, a memory capable of reading and writing (RAM: Random Access Memory), which is an example of storage means, and a memory dedicated to reading (ROM: Read Only Memory) for storing various programs.

The ROM of the storage battery monitoring unit 42, for example, is installed with a corrected full charge capacity estimation program for estimating the corrected full charge capacity ($FCC_{adj}$), and a state of charge estimation program for estimating the state of charge (SOC) and the state of power (SOP). These estimation programs are read into the RAM, and executed by the CPU which is a computer. That is, the full charge capacity estimation program and the state of charge estimation program are adapted to make the CPU function to execute a procedure of estimating the full charge capacity and a procedure of estimating the state of charge.

Hereinbelow, the state of charge estimation unit 100 provided in the storage battery monitoring unit 42 will be described.

The state of charge estimation unit 100 acquires data on the measurement results such as the charge/discharge current value of the secondary battery unit 2, and based on the data, estimates the state of charge of the secondary battery unit 2. In detail, the state of charge estimation unit 100 estimates the state of charge (SOC) of the secondary battery unit 2 from a formula (1) indicated below, or its state of power (SOP) from a formula (2) indicated below. That is, the state of charge estimation unit 100 estimates the state of charge or the state of power (SOP) of the secondary battery unit 2 by a so-called current integration method.

The state of power (SOP) represents chargeable/dischargeable power determined based on electric energy (Wh) obtained by multiplying battery capacity (Ah) by voltage (V). As seen here, SOP can be determined by multiplication using voltage measured at the same time as current. In descriptions to be offered later on, even the formula employing the state of charge (SOC) is similarly applicable to the state of power (SOP).

[Equation 32]

$$SOC = SOC_{last} + \sum_{k=1}^{n} \frac{i_k(t_k - t_{k-1})}{FCC_{adj}} \qquad (1)$$

[Equation 33]

$$SOP = SOP_{last} + \sum_{k=1}^{n} \frac{p_k(t_k - t_{k-1})}{FCC_{adj}} \qquad (2)$$

where $i_k$, $p_k$ and $t_k$ are defined as follows:

$i_k$: Charge/discharge current of a secondary battery unit, representing the current value of the charge/discharge current being measured;
$p_k$: Input/output power of the secondary battery unit, representing the power value of the input/output power; and
$t_k$: Usage time of the secondary battery unit

The state of charge estimation unit 100 makes an estimation of the state of charge of the secondary battery unit 2 at predetermined intervals as stated earlier, and $SOC_{last}$ in the formula (1) above represents the state of charge of the secondary battery unit 2 estimated last time or previously by the state of charge estimation unit 100. That is, $SOC_{last}$ is the previous value of the state of charge of the secondary battery unit 2 estimated by the state of charge estimation unit 100. In the formula (1), $i_k$ is the charge/discharge current value of the secondary battery unit 2, while $(t_k - t_{k-1})$ is the elapsed time since the previous estimation up to the present estimation.

$i_k \times (t_k - t_{k-1})$ corresponds to the quantity of electric charge (Q) that has went into and out of the secondary battery unit from the previous estimation until the present estimation, so that $i_k$ takes into consideration changes in the current value of the charge/discharge current being measured. By measuring the current value over time, it can be put to use. If the conditions are met, representative values such as a value at the time of measurement, an average value, a mean value, a maximum value, and a minimum value can be used. If the time interval from the previous estimation until the present estimation is short, or there are few changes in the current value, the amount of data can be rendered small. Hence, it is preferred to use the current value at the time of measurement.

It suffices that the timing at which measurements are made and data are acquired be selected, as appropriate, in accordance with the status of use of the system or the intended object. Data may be acquired at points where any physical quantities are changed, such as when charge and discharge are exchanged, if the current value changes greatly, or if the temperature rapidly changes. Alternatively, data may be acquired at regular time intervals. In case accurate SOC estimation is desirable, it is preferred to make measurements at short time intervals. The measured data need to be linked to the operating time and kept in storage.

$FCC_{adj}$ (FCC adjust) in the formula (1) represents the corrected value of the full charge capacity (hereinafter referred to as corrected full charge capacity) of the secondary battery unit 2 at the time of each estimation of the state of charge of the secondary battery unit 2. The state of charge estimation unit 100 is configured to include a corrected full charge capacity estimation unit 110 as a full charge capacity estimation device, and the full charge capacity $FCC_{adj}$ is estimated (calculated) by the corrected full charge capacity estimation unit 110.

The corrected full charge capacity estimation unit 110 measures a charge/discharge current value $i_j$ of the secondary battery unit 2, a unit temperature $Temp_j$ which is the present temperature of the secondary battery unit 2, and a state of health $SOH_j$ of the secondary battery unit 2 at the same timing, and calculates the corrected full charge capacity by use of a Weibull function taking, as a variable, at least one of indices based on the respective parameters.

If the temperature ($Temp_j$) is measured over time, its value can be used. If the conditions are met, representative values such as a value at the time of measurement, an average value, a mean value, a maximum value, and a minimum value can also be used. If the time interval from the previous estimation until the present estimation is short, or if changes in the temperature are few, the amount of data can be rendered small. Hence, it is preferred to use the temperature at the time of measurement.

In more detail, the corrected full charge capacity estimation unit 110 has a current value acquisition means 111, a unit temperature acquisition means 112, a state of health acquisition means 113, and a corrected full charge capacity calculation means 115.

The current value acquisition means 111 acquires the present charge/discharge current value $i_j$ as the charge/discharge current value which is the current value at the time of charging and discharging of the secondary battery unit 2. The unit temperature acquisition means 112 acquires the present unit temperature $Temp_j$ as the unit temperature which is the temperature of the secondary battery unit 2. The state of health acquisition means 113 acquires the present state of health $SOH_j$ of the secondary battery unit 2.

How to acquire the state of health ($SOH_j$) is not particularly limited. For example, however, an SOC-OCV curve or a charge/discharge capacity-OCV curve obtained from a reference cell, etc. prepared in advance is rendered ready for use, SOC or charge/discharge capacity at the time of measurement is obtained from the value of OCV, and it is compared with SOC or capacity value obtainable from the present quantity of electric charge as a result of current integration, whereby the state of health ($SOH_j$) can be derived. It can also be derived from elapsed time, cycle count, usage environment, status of battery cell, etc. by experiments conducted in advance. The state of health ($SOH_j$) can also be derived by a method using a Weibull plot.

In the present embodiment, as stated above, the storage battery monitoring unit 42 functions as a monitoring device (CMU), detects charge/discharge current value $i_j$, input/output power value $p_j$, unit temperature $Temp_j$, etc., and estimates the state of health $SOH_j$. Thus, the current value acquisition means 111, unit temperature acquisition means 112, and state of health acquisition means 113 acquire the charge/discharge current value $i_j$ and unit temperature $Temp_j$ detected by the storage battery monitoring unit 42 at predetermined timings, and acquire the state of health $SOH_j$ estimated by the storage battery monitoring unit 42 at a predetermined timing.

The timings for detecting the charge/discharge current value $i_j$, input/output power value $p_j$, unit temperature $Temp_j$, etc., and acquiring data on measurement of the state of health $SOH_j$ may be selected, as appropriate, in accordance with the usage status and purpose of the system. The timings may be the same as the timings for acquiring the data, or if necessary, the respective data may be acquired individually.

Methods for acquiring the charge/discharge current value $i_j$, input/output power value $p_j$, unit temperature $Temp_j$, and state of health $SOH_j$ are not particularly limited. For example, estimations of the charge/discharge current value $i_j$, input/output power value $p_j$, unit temperature $Temp_j$, and state of health $SOH_j$ may be made by the corrected full charge capacity estimation unit 110.

The corrected full charge capacity calculation means 115 calculates a corrected full charge capacity with the use of a first correction factor (CF1). At the same timing, the charge/discharge current value $i_j$ of the secondary battery unit 2, the input/output power value $p_j$ of the secondary battery unit 2, the unit temperature $Temp_j$ which is the temperature of the secondary battery unit 2, and the state of health $SOH_j$ of the secondary battery unit 2 are obtained. Using a Weibull function, which takes as a variable at least one of the following four indices,

First index (I): Index based on the current value ($i_j$) of the charge/discharge current at the time of measurement,
Second index (P): Index based on the power value ($p_j$) of the input/output power at the time of measurement,
Third index (T): Index based on the temperature ($Temp_j$) of the secondary battery unit at the time of measurement, and
Fourth index (S): Index based on the state of health ($SOH_j$) of the secondary battery unit at the time of measurement,

the corrected full charge capacity calculation means 115 calculates the first correction factor (CF1). It is preferred, however, to use only one of the first index (I) and the second index (P).

Representative examples of the indices are as indicated by the following formulas:

[Equation 34]

$$I = Current \ or \ log_n \ (current) \ or \ (current)^n$$

$$S = 1 - SOH \ or \ SOH \ or \ \frac{SOH[\%]}{100} \ or \ \frac{100-SOH[\%]}{100} \ or \ log_n(1-SOH) \ or \ log_n(SOH) \ or \ (SOH)^n \ or$$

$$(1-SOH)^n$$

$$T = \frac{1}{(|absolute \ zero|+Temp)} \ or \ Temp \ or \ Temp+|absolute \ zero| \ or \ ln\left(\frac{1}{(|absolute \ zero|+Temp)}\right) \ or$$

$$ln(Temp+|absolute \ zero|) \ or \ \left(\frac{1}{(|absolute \ zero|+Temp)}\right)^n \ or \ (Temp+|absolute \ zero|)^n$$

In calculating the first correction factor (CF1), the following formulae can be given as examples:

[Equation 35]

$$\text{Formula 11: } CF1 = \exp\left\{-\left(\frac{x(1)}{\eta}\right)^m\right\} \times x(3) \quad \begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix}$$

$$\text{Formula 12: } CF1 = \exp\left\{-\left(\frac{x(1)}{\eta}\right)^m\right\} \times x(3) \quad \begin{bmatrix} m \\ ln(\eta) \end{bmatrix} = \begin{bmatrix} prm(1) \\ prm(3) \end{bmatrix} \times x(2) + \begin{bmatrix} prm(2) \\ prm(4) \end{bmatrix}$$

$$\text{Formula 13: } CF1 = \exp\left\{-\left(\frac{x(1)}{\eta}\right)^m\right\} \times x(3) \quad \begin{bmatrix} ln(m) \\ ln(\eta) \end{bmatrix} = \begin{bmatrix} prm(1) \\ prm(3) \end{bmatrix} \times x(2) + \begin{bmatrix} prm(2) \\ prm(4) \end{bmatrix}$$

$$\text{Formula 14: } CF1 = \exp\left\{-\left(\frac{x(1)}{\eta}\right)^m\right\} \div x(3) \quad \begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix}$$

$$\text{Formula 15: } CF1 = \exp\left\{-\left(\frac{x(1)}{\eta}\right)^m\right\} \begin{bmatrix} m \\ \eta \end{bmatrix} = \left\{ \begin{bmatrix} prm(1) \\ prm(5) \end{bmatrix} \times x(3) + \begin{bmatrix} prm(2) \\ prm(6) \end{bmatrix} \right\} \times \chi(2) +$$
$$\begin{bmatrix} prm(3) \\ prm(7) \end{bmatrix} \times x(3) + \begin{bmatrix} prm(4) \\ prm(8) \end{bmatrix}$$

$$\text{Formula 16: } CF1 = \exp\left\{-\left(\frac{x(1)}{\eta}\right)^m\right\} \begin{bmatrix} m \\ \eta \end{bmatrix} = \left\{ \begin{bmatrix} prm(1) \\ prm(5) \end{bmatrix} \times x(3) + \begin{bmatrix} prm(2) \\ prm(6) \end{bmatrix} \right\} \div \chi(2) +$$
$$\begin{bmatrix} prm(3) \\ prm(7) \end{bmatrix} \times x(3) + \begin{bmatrix} prm(4) \\ prm(8) \end{bmatrix}$$

$$\text{Formula 17: } CF1 = \exp\left\{-\left(\frac{x(1)}{\eta}\right)^m\right\} \begin{bmatrix} m \\ \eta \end{bmatrix} = \left\{ \begin{bmatrix} prm(1) \\ prm(5) \end{bmatrix} \times x(3) + \begin{bmatrix} prm(2) \\ prm(6) \end{bmatrix} \right\} - \chi(2) +$$
$$\begin{bmatrix} prm(3) \\ prm(7) \end{bmatrix} \times x(3) + \begin{bmatrix} prm(4) \\ prm(8) \end{bmatrix}$$

$$\text{Formula 18: } CF1 = \exp\left\{-\left(\frac{x(1)}{\eta}\right)^m\right\} \begin{bmatrix} m \\ \eta \end{bmatrix} = \left\{ \begin{bmatrix} prm(1) \\ prm(5) \end{bmatrix} \times x(3) + \begin{bmatrix} prm(2) \\ prm(6) \end{bmatrix} \right\} + \chi(2) +$$
$$\begin{bmatrix} prm(3) \\ prm(7) \end{bmatrix} \times x(3) + \begin{bmatrix} prm(4) \\ prm(8) \end{bmatrix}$$

In the formulae 11 to 18, any indices among the first index (I), the second index (P), the third index (T), and the fourth index (S) are set for $\chi(1)$, $x(2)$ and $x(3)$ so as not to overlap.

In the formulae 11 to 18, the right-side formulas are fitting formulas for determining m and $\eta$, and prm(1), prm(2), prm(3), ..., prm(8) represent any numbers to be obtained at the time of fitting.

Furthermore, the corrected full charge capacity calculation means 115 may obtain the first correction factor by selecting a plurality of any functions from among the Weibull function using, as the variable, the first index (I) based on the charge/discharge current value ($i_j$) at the time of measurement, the Weibull function using, as the variable, the second index (P) based on the power value ($p_j$) of the input/output power at the time of measurement, the Weibull function using, as the variable, the third index (T) based on the temperature ($Temp_j$), at the time of measurement, of the secondary battery unit, and the Weibull function using, as the variable, the fourth index (S) based on the state of health ($SOH_j$), at the time of measurement, of the secondary battery unit, and performing predetermined four arithmetic operations of the plurality of functions.

[Equation 36-1]

Formula 21: CF1 $= \exp\left\{-\left(\frac{x(1)}{\eta_1}\right)^{m_1}\right\} \times \exp\left\{-\left(\frac{x(2)}{\eta_2}\right)^{m_2}\right\}$ $\begin{bmatrix} m_1 \\ \eta_1 \\ m_2 \\ \eta_2 \end{bmatrix} = \begin{bmatrix} p\ r\ m\ (1) \\ p\ r\ m\ (3) \\ p\ r\ m\ (5) \\ p\ r\ m\ (7) \end{bmatrix} \times \chi(3) +$

$\begin{bmatrix} p\ r\ m\ (2) \\ p\ r\ m\ (4) \\ p\ r\ m\ (6) \\ p\ r\ m\ (8) \end{bmatrix}$

Formula 22: CF1 $= \exp\left\{-\left(\frac{x(1)}{\eta_1}\right)^{m_1}\right\} + \exp\left\{-\left(\frac{x(2)}{\eta_2}\right)^{m_2}\right\}$ $\begin{bmatrix} m_1 \\ \eta_1 \\ m_2 \\ \eta_2 \end{bmatrix} = \begin{bmatrix} p\ r\ m\ (1) \\ p\ r\ m\ (3) \\ p\ r\ m\ (5) \\ p\ r\ m\ (7) \end{bmatrix} \times \chi(3) +$

$\begin{bmatrix} p\ r\ m\ (2) \\ p\ r\ m\ (4) \\ p\ r\ m\ (6) \\ p\ r\ m\ (8) \end{bmatrix}$

Formula 23: CF1 $= \exp\left\{-\left(\frac{x(1)}{\eta_1}\right)^{m_1}\right\} - \exp\left\{-\left(\frac{x(2)}{\eta_2}\right)^{m_2}\right\}$ $\begin{bmatrix} m_1 \\ \eta_1 \\ m_2 \\ \eta_2 \end{bmatrix} = \begin{bmatrix} p\ r\ m\ (1) \\ p\ r\ m\ (3) \\ p\ r\ m\ (5) \\ p\ r\ m\ (7) \end{bmatrix} \times \chi(3) +$

$\begin{bmatrix} p\ r\ m\ (2) \\ p\ r\ m\ (4) \\ p\ r\ m\ (6) \\ p\ r\ m\ (8) \end{bmatrix}$

Formula 24: CF1 $= \exp\left\{-\left(\frac{x(1)}{\eta_1}\right)^{m_1}\right\} - \exp\left\{-\left(\frac{x(2)}{\eta_2}\right)^{m_2}\right\}$ $\begin{bmatrix} m_1 \\ \eta_1 \\ m_2 \\ \eta_2 \end{bmatrix} = \begin{bmatrix} p\ r\ m\ (1) \\ p\ r\ m\ (3) \\ p\ r\ m\ (5) \\ p\ r\ m\ (7) \end{bmatrix} \times \chi(3) +$

$\begin{bmatrix} p\ r\ m\ (2) \\ p\ r\ m\ (4) \\ p\ r\ m\ (6) \\ p\ r\ m\ (8) \end{bmatrix}$

Formula 25: CF1 $= \exp\left\{-\left(\frac{x(1)}{prm(1)}\right)^{prm(2)}\right\} \times \exp\left\{-\left(\frac{x(2)}{prm(3)}\right)^{prm(4)}\right\} \times \exp\left\{-\left(\frac{x(3)}{prm(5)}\right)^{prm(6)}\right\}$

Formula 26: CF1 $= \left[\exp\left\{-\left(\frac{x(1)}{prm(1)}\right)^{prm(2)}\right\} + \exp\left\{-\left(\frac{x(2)}{prm(3)}\right)^{prm(4)}\right\}\right]$

$- \exp\left\{-\left(\frac{x(3)}{prm(5)}\right)^{prm(6)}\right\}$

Formula 27: CF1 $= \exp\left\{-\left(\frac{x(1)}{prm(1)}\right)^{prm(2)}\right\} \div \exp\left\{-\left(\frac{x(2)}{prm(3)}\right)^{prm(4)}\right\} \div \exp\left\{-\left(\frac{x(3)}{prm(5)}\right)^{prm(6)}\right\}$

Formula 28: CF1 $= \exp\left\{-\left(\frac{x(1)}{prm(1)}\right)^{prm(2)}\right\} \div \exp\left\{-\left(\frac{x(2)}{prm(3)}\right)^{prm(4)}\right\} \times \exp\left\{-\left(\frac{x(3)}{prm(5)}\right)^{prm(6)}\right\}$

Formula 29: CF1 $= \exp\left\{-\left(\frac{x(1)}{prm(1)}\right)^{prm(2)}\right\} \times \exp\left\{-\left(\frac{x(2)}{prm(3)}\right)^{prm(4)}\right\} \div \exp\left\{-\left(\frac{x(3)}{prm(5)}\right)^{prm(6)}\right\}$

Formula 30: CF1 $= \exp\left\{-\left(\frac{x(1)}{prm(1)}\right)^{prm(2)}\right\} + \exp\left\{-\left(\frac{x(2)}{prm(3)}\right)^{prm(4)}\right\} \times \exp\left\{-\left(\frac{x(3)}{prm(5)}\right)^{prm(6)}\right\}$

Formula 31: CF1 $= \exp\left\{-\left(\frac{x(1)}{prm(1)}\right)^{prm(2)}\right\} - \exp\left\{-\left(\frac{x(2)}{prm(3)}\right)^{prm(4)}\right\} \times \exp\left\{-\left(\frac{x(3)}{prm(5)}\right)^{prm(6)}\right\}$

Formula 32: CF1 $= \exp\left\{-\left(\frac{x(1)}{prm(1)}\right)^{prm(2)}\right\} + \exp\left\{-\left(\frac{x(2)}{prm(3)}\right)^{prm(4)}\right\} \div \exp\left\{-\left(\frac{x(3)}{prm(5)}\right)^{prm(6)}\right\}$

Formula 33: CF1 $= \exp\left\{-\left(\frac{x(1)}{prm(1)}\right)^{prm(2)}\right\} - \exp\left\{-\left(\frac{x(2)}{prm(3)}\right)^{prm(4)}\right\} \div \exp\left\{-\left(\frac{x(3)}{prm(5)}\right)^{prm(6)}\right\}$

Formula 34: CF1 $= \exp\left\{-\left(\frac{x(1)}{prm(1)}\right)^{prm(2)}\right\} + \exp\left\{-\left(\frac{x(2)}{prm(3)}\right)^{prm(4)}\right\} + \exp\left\{-\left(\frac{x(3)}{prm(5)}\right)^{prm(6)}\right\}$

Formula 35: CF1 $= \exp\left\{-\left(\frac{x(1)}{prm(1)}\right)^{prm(2)}\right\} - \exp\left\{-\left(\frac{x(2)}{prm(3)}\right)^{prm(4)}\right\} + \exp\left\{-\left(\frac{x(3)}{prm(5)}\right)^{prm(6)}\right\}$

[Equation 36-2]

$$\text{Formula 36: } CF1 = \exp\left\{-\left(\frac{x(1)}{prm(1)}\right)^{prm(2)}\right\} - \exp\left\{-\left(\frac{x(2)}{prm(3)}\right)^{prm(4)}\right\} - \exp\left\{-\left(\frac{x(3)}{prm(5)}\right)^{prm(6)}\right\}$$

$$\text{Formula 37: } CF1 = \left[\exp\left\{-\left(\frac{x(1)}{prm(1)}\right)^{prm(2)}\right\} + \exp\left\{-\left(\frac{x(2)}{prm(3)}\right)^{prm(4)}\right\}\right] \times \exp\left\{-\left(\frac{x(3)}{prm(5)}\right)^{prm(6)}\right\}$$

$$\text{Formula 38: } CF1 = \left[\exp\left\{-\left(\frac{x(1)}{prm(1)}\right)^{prm(2)}\right\} - \exp\left\{-\left(\frac{x(2)}{prm(3)}\right)^{prm(4)}\right\}\right] \times \exp\left\{-\left(\frac{x(3)}{prm(5)}\right)^{prm(6)}\right\}$$

$$\text{Formula 39: } CF1 = \left[\exp\left\{-\left(\frac{x(1)}{prm(1)}\right)^{prm(2)}\right\} + \exp\left\{-\left(\frac{x(2)}{prm(3)}\right)^{prm(4)}\right\}\right] \div \exp\left\{-\left(\frac{x(3)}{prm(5)}\right)^{prm(6)}\right\}$$

$$\text{Formula 40: } CF1 = \left[\exp\left\{-\left(\frac{x(1)}{prm(1)}\right)^{prm(2)}\right\} - \exp\left\{-\left(\frac{x(2)}{prm(3)}\right)^{prm(4)}\right\}\right] \div \exp\left\{-\left(\frac{x(3)}{prm(5)}\right)^{prm(6)}\right\}$$

In the formulae 21 to 40, prm(1) to prm (6) are derived from the relationship $FCC_{adj}$ = FCC × CF1 × CF2. That is, the capacity in the past experimental data is set at $FCC_{adj}$, the initial capacity (FCC), the first index, the third index and the fourth index at the time of experiments are substituted into the formula, and the result is subjected to fitting, whereby the parameters can be obtained. Accordingly, the object can be attained if the past experimental data are available.

The corrected full charge capacity calculation means 115 may calculate the corrected full charge capacity on the basis of a second correction factor which is determined by a second function including a Weibull function taking the second index as the variable.

The corrected full charge capacity calculation means 115 calculates the second correction factor (CF2) by the second function as indicated by a formula (a) below. As shown by a formula (b) offered below, the initial full charge capacity (FCC) is multiplied by the second correction factor (second function) to calculate the corrected full charge capacity ($FCC_{adj}$).

The second correction factor is derived from the relationship between the temperature of the secondary battery unit and the initial battery capacity of the battery unit which is provided beforehand.

[Equation 37]

$$CF2 = \exp\left\{-\left(Temp_j/\eta_{std\_T}\right)^{m_{std\_T}}\right\} \quad (a)$$

$$FCC_{adj} = FCC \times CF2 \quad (b)$$

The initial full charge capacity (FCC) of the secondary battery unit 2 is a value which has been obtained in advance from the capacity of the secondary battery unit 2 when rendered unused, or by experiments using a reference cell of the same kind.

The initial full charge capacity (FCC) can be obtained by charging or discharging at a low value of current charged or discharged. The rate of the current value is preferably set at 0.01C or less for measurements. The charge/discharge capacity of the battery is affected by the measuring temperature, but a temperature in the vicinity of room temperature is acceptable. If possible, an estimated approximate value or the like may be employed. As a method of approximation, there can be employed a method which comprises taking a plurality of full charge capacities at different temperatures, and plotting their relationship, followed by using a maximum value, or a method comprising taking a plurality of different rates of temperatures and currents, and using the least squares method, etc.

The coefficients $m_{std\_T}$ and $\eta_{std\_T}$ used for the second correction factor in the formula (a) are values obtained beforehand by experiments using a reference cell of the same kind, and they are calculated, for example, in the following manner:

A Weibull function is expressed as a formula of a linear function, if natural logarithms are taken twice to transform the formula. In connection with the following formula (c) as an example of a Weibull function, for example, the natural logarithm is taken twice to transform the formula. As a result, it is expressed as a formula of a linear function as shown by the following formula (d). Thus, the parameters m and $\eta$ of the Weibull function can be calculated from the coefficients in the formula.

[Equation 38]

$$\frac{Y}{100} = \exp\left\{-\left(\frac{ln(x)}{\eta}\right)^{m}\right\} \quad (c)$$

$$\ln\left\{\ln\left(\frac{Y}{100}\right)\right\} = m \times ln(ln(X)) - m \times ln(\eta) \quad (d)$$

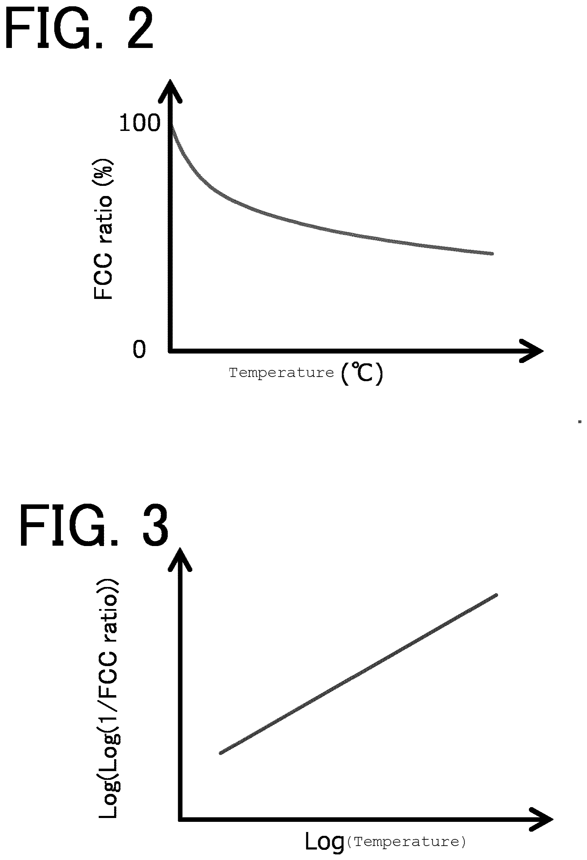

In connection with the second function in the aforementioned formula (3) as well, the coefficients $m_{std\_T}$ and $\eta_{std\_T}$ are obtained using the above-identified technique. Concretely, the relationship between the unit temperature Temp, which is the battery unit temperature of the reference cell, and the FCC ratio is found experimentally. The FCC ratio is the proportion of the experimentally measured full charge capacity to the set capacity FCC. Changes in the full charge capacity of the secondary battery unit 2 when the temperature Temp is changed are experimentally measured, and the relation between the unit temperature and the FCC ratio is determined from the results of the measurements. Fig 2 is a graph showing the relationship between the unit temperature and the FCC ratio found from the experiments. As shown in Fig. 2, the value of the ratio shows a tendency toward gradual lowering as the unit temperature Temp rises.

From the relationship between the unit temperature and the FCC ratio found experimentally as described above, a Weibull plot is prepared. That is, the abscissa represents ln (unit temperature), while the ordinate represents ln(ln(1/FCC ratio)), and the respective points are Weibull plotted to draw a graph. The plots of this graph are subjected to a fitting technique such as regression analysis (e.g., least squares method). From the FCC ratio, a linear prediction line as shown in Fig. 3 is obtained, and from the slope and intercept of this prediction line, the coefficients $m_{std\_T}$ and $\eta_{std\_T}$ used for the second function are determined.

The least squares method is cited here as the fitting technique, but a nonlinear method such as Levenberg-Marquardt algorithm can also be used. The fitting technique can be carried out using simulation software or spreadsheet software.

The corrected full charge capacity calculation means 115 multiplies the initial full charge capacity (FCC), the first correction factor, and the second correction factor together to calculate a corrected full charge capacity. By using both of the first correction factor and the second correction factor, a more accurate state of charge of the second battery unit 2 can be obtained.

From now on, a concrete way of obtaining the first correction factor (CF1) will be described.

In the present embodiment, for example, the corrected full charge capacity calculation means 115 can be illustrated as indicated by a formula (e) shown below.

For $x$ (1) and $x$ (3), any indices among the first index (I), the second index (P), the third index (T), and the fourth index (S) are set so as not to overlap.

For example, a Weibull function taking the first Index, constituted based on the charge/discharge current value $i_j$, as the variable $x$ (1), and a Weibull function taking the fourth Index, constituted based on the state of health $SOH_j$, as the variable $x$ (3), are multiplied together to calculate the first correction factor (CF1).

[Equation 39]

$$CF1 = \exp\left\{-\left(\frac{x(1)}{\eta}\right)^{m}\right\} \times x(3) \quad (e)$$

The corrected full charge capacity calculation means 115 calculates the coefficients m and $\eta$, which are used for the first function, from a third function using, as variables, indices other than the indices used as the variables for the first function for calculating the first correction factor CF1. For $x$ (2), an index different from the indices used for $x$ (1) and $x$ (3) is set.

If, as stated above, the first index constituted based on the charge/discharge current value $i_j$ and the fourth index constituted based on the state of health $SOH_j$ are used the variables for $x$ (1) and $\chi$(3) in the first function, the coefficients m and $\eta$ are calculated from the third function using the index other than them, i.e., the third index, as the variable. In the present embodiment, for example, the corrected full charge capacity calculation means 115 calculates the coefficients m and $\eta$ used for the first function by the third function shown in the following formula (f).

[Equation 40]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (f)$$

In the same manner as for obtaining $m_{std\_T}$ and $\eta_{std\_T}$, those coefficients are calculated by Weibull plotting the relationship between the capacity and the index used for $\chi(2)$ used for the formula (8), followed by fitting. The fitting technique can be carried out using simulation software or spreadsheet software. The parameters prm(1) to prm(4) represent values obtained in accordance with fitting.

In the present embodiment, the first correction factor is calculated using the above formulae (e) and (f), but the first correction factor can also be calculated using other formula. For example, a combination of the following formulae (g) and (h) can be cited.

[Equation 41]

$$CF1 = \exp\left\{-\left(\frac{x(1)}{ln(\eta)}\right)^{\ln(m)}\right\} \times x(3) \quad (g)$$

[Equation 42]

$$\begin{bmatrix} ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \quad (h)$$

In the formula (h), the coefficients m and $\eta$ are calculated in the form of ln(m) and ln($\eta$). In this case, for the values of ln(m) and ln($\eta$), the coefficients m and $\eta$ are calculated using exp, and can be used for the formula (g).

Furthermore, the coefficients m and $\eta$ may be obtained as a combination of m and ln($\eta$).

Even if other coefficients m and $\eta$ are to be obtained, their combination can be replaced by m and ln($\eta$), or ln(m) and ln($\eta$).

In the present embodiment, the first correction factor is calculated using the formulae (e) and (f), but the first correction factor can be calculated using other formulae. A combination of the following formulae (i) and (j), and a combination of the following formulae (k) and (l) can be named.

[Equation 43]

$$CF1 = \exp\left\{-\left(\frac{x(1)}{\eta}\right)^{m}\right\} \cdot \cdot \cdot (i)$$

$$\begin{bmatrix} m \\ \eta \end{bmatrix} = \begin{bmatrix} prm(1) \\ prm(5) \end{bmatrix} \times x(3) + \begin{bmatrix} prm(2) \\ prm(6) \end{bmatrix} \times \chi(2) + \begin{bmatrix} prm(3) \\ prm(7) \end{bmatrix} \times x(3) + \begin{bmatrix} prm(4) \\ prm(8) \end{bmatrix} \quad (j)$$

$$CF1 = \exp\left\{-\left(\frac{x(1)}{\eta_1}\right)^{m_1}\right\} - \exp\left\{-\left(\frac{x(2)}{\eta_2}\right)^{m_2}\right\} \quad (k)$$

$$\begin{bmatrix} m_1 \\ \eta_1 \\ m_2 \\ \eta_2 \end{bmatrix} = \begin{bmatrix} prm(1) \\ prm(3) \\ prm(5) \\ prm(7) \end{bmatrix} \times \chi(3) + \begin{bmatrix} prm(2) \\ prm(4) \\ prm(6) \\ prm(8) \end{bmatrix} \quad ...(l)$$

The coefficients m and $\eta$ can be obtained by use of simulation software or the like based on the relationship between the capacity and the parameters of the formulae (j) and (l), followed by simultaneous fitting.

Besides, the first correction factor can be calculated using formulae (m), (n), etc. shown below. In calculating the first correction factor from the formula (m) or (n), the parameters prm(1) to prm(6) in the respective formulas are derived from the relationship $FCC_{adj} = FCC \times CF1 \times CF2$. They can be obtained by fitting the capacity in the past experimental data using $FCC_{adj}$, initial capacity (FCC), and the first index, third index and fourth index at the time of experiments.

[Equation 44]

$$CF1 = \exp\left\{-\left(\frac{x(1)}{prm(1)}\right)^{prm(2)}\right\} \times \exp\left\{-\left(\frac{x(2)}{prm(3)}\right)^{prm(4)}\right\} \times \exp\left\{-\left(\frac{x(3)}{prm(5)}\right)^{prm(6)}\right\} \quad (m)$$

$$CF1 = \left[\exp\left\{-\left(\frac{x(1)}{prm(1)}\right)^{prm(2)}\right\} + \exp\left\{-\left(\frac{x(2)}{prm(3)}\right)^{prm(4)}\right\}\right] - \exp\left\{-\left(\frac{x(3)}{prm(5)}\right)^{prm(6)}\right\} \quad (n)$$

<Test Examples>

Under predetermined conditions, tests were conducted (Test Examples 1 to 4) in the following manner: The secondary battery unit 2 was charged or discharged. During this period, in each of state of charge estimation devices of Examples 1 to 12 and Comparative Examples 1 and 2, corrected full charge capacity was calculated, and the state of charge of the secondary battery unit 2 was estimated (calculated) based on the calculated corrected full charge capacity.

(Examples 1 to 12)

In the state of charge estimation devices of Examples 1 to 12, any of the aforementioned formulae (e) to (n) was used as a calculation formula for the first correction factor CF1j, as shown in Table 1 below, and the variable x (x(1), x(2), x(3)) shown in Table 1 was used to calculate corrected full charge capacity $FCC_{adj}$. Moreover, the state of charge of the secondary battery unit 2 was estimated using the corrected full charge capacity $FCC_{adj}$.

[Table 1]

| | CF1j Calculation formula | Variable x | | |
|---|---|---|---|---|
| | | x(1) | x(2) | x(3) |
| Ex.1 | Formulae(7)(8) | Natural logarithm current [ln(current)] | Reciprocal of absolute temperature[$K^{-1}$] | Reciprocal of SOH [$SOH^{-1}$] |
| Ex.2 | | Natural logarithm current [ln(current)] | Reciprocal of absolute temperature[$K^{-1}$] | Reciprocal of SOH [$SOH^{-1}$] |
| Ex.3 | Formulae(11)(12) | Natural logarithm current [ln(current)] | Reciprocal of absolute temperature[$K^{-1}$] | 1- SOH |
| Ex.4 | Formulae(13)(14) | Natural logarithm current [ln(current)] | Temperature(°C) | SOH |
| Ex.5 | Formula(15) | Current | Temperature(°C) | SOH |
| Ex.6 | Formula(15) | Natural logarithm current [ln(current)] | Temperature(°C) | SOH |
| Ex.7 | Formula(15) | Natural logarithm current [ln(current)] | Reciprocal of absolute temperature[$K^{-1}$] | 1- SOH |
| Ex.8 | Formula(15) | Current | Reciprocal of absolute temperature[$K^{-1}$] | SOH |
| Ex.9 | Formula(16) | Natural logarithm current [ln(current)] | Temperature(°C) | SOH |
| Ex.10 | Formula(16) | Natural logarithm current [ln(current)] | Reciprocal of absolute temperature[$K^{-1}$] | 1- SOH |
| Ex.11 | Formula(16) | Natural logarithm current [ln(current)] | Reciprocal of absolute temperature[$K^{-1}$] | Reciprocal of SOH [$SOH^{-1}$] |
| Ex.12 | Formula(16) | Current | Reciprocal of absolute temperature[$K^{-1}$] | SOH |

(Comparative Example 1)

In the state of charge estimation device of Comparative Example 1, full charge capacity was set at a fixed value (for example, initial full charge capacity FCC), and the state of charge of the secondary battery unit 2 was estimated (calculated).

(Comparative Example 2)

In the state of charge estimation device of Comparative Example 2, full charge capacity was estimated (calculated) based on a prestored map, and the state of charge of the secondary battery unit 2 was estimated (calculated) based on the full charge capacity.

<Test Example 1>

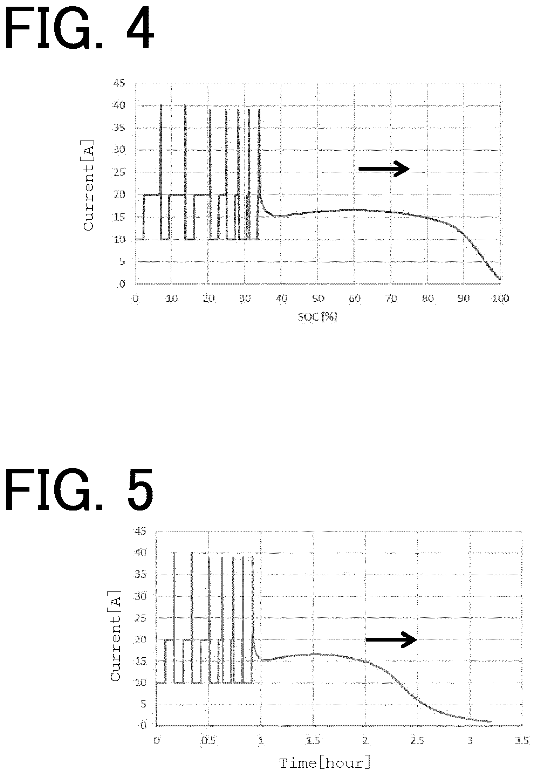

As shown in Table 2 below, the secondary battery unit 2 was charged, under the conditions: execution temperature 10°C and SOH=87.6%, until the actual state of charge finally reached (actual final SOC) became 100%. Figs. 4 and 5 are graphs illustrating changes in the current value of the secondary battery unit 2 during this period.

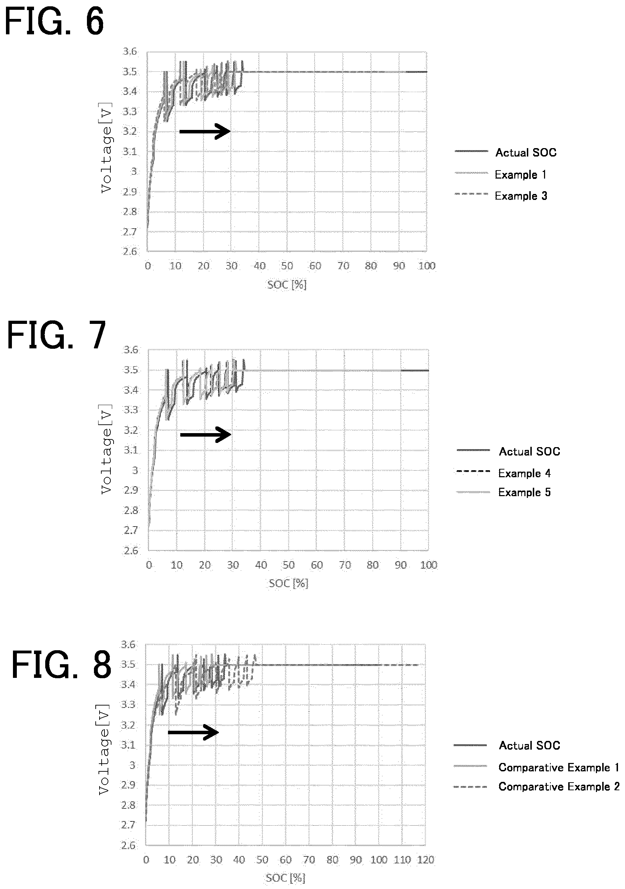

During the charging of the secondary battery unit 2, the corrected full charge capacity $FCC_{adj}$ of the secondary battery unit 2 was calculated in the state of charge estimation device. Using the corrected full charge capacity $FCC_{adj}$, the state of charge of the secondary battery unit 2 was estimated (calculated). Figs. 6 to 8 are graphs illustrating the actual state of charge (actual SOC) of the secondary battery unit during charging, the state of charge estimated in each of Examples 1, 3 to 5 and Comparative Examples 1 and 2, and changes in the voltage of the secondary battery unit. As one of the test results, the finally arrived state of charge (final SOC), the state of charge after charging, is shown in Table 3 below.

<Test Example 2>

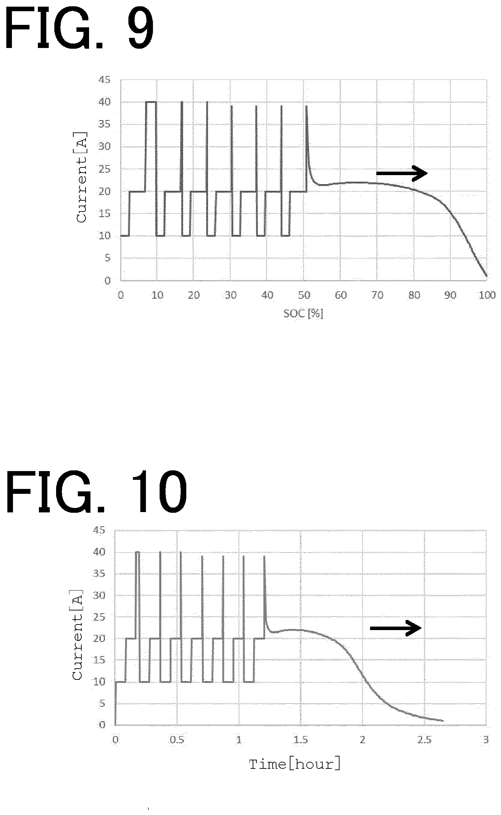

As shown in Table 2 below, the secondary battery unit 2 was charged, under the conditions: execution temperature 20°C and SOH=87.6%, until the actual state of charge finally reached (actual final SOC) became 100%. Figs. 9 and 10 are graphs illustrating changes in the current value of the secondary battery unit 2 during this period.

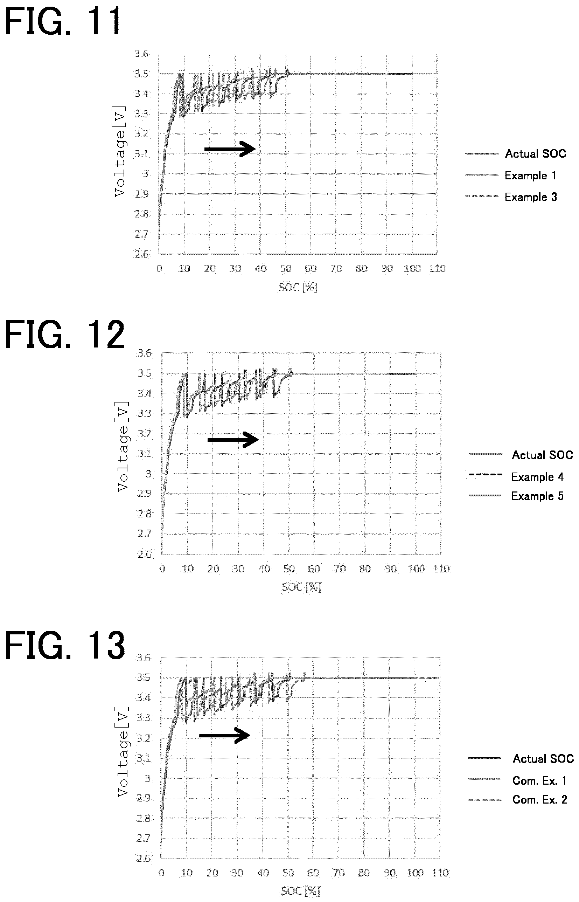

During the charging of the secondary battery unit 2, the corrected full charge capacity $FCC_{adj}$ of the secondary battery unit 2 was calculated in the state of charge estimation device. Using the corrected full charge capacity $FCC_{adj}$, the state of charge of the secondary battery unit 2 was estimated (calculated). Figs. 11 to 13 are graphs illustrating the actual state of charge (actual SOC) of the secondary battery unit during charging, the state of charge estimated in each of Examples 1, 3 to 5 and Comparative Examples 1 and 2, and changes in the voltage of the secondary battery unit. As one of the test results, the finally arrived state of charge (final SOC), the state of charge after charging, is shown in Table 3 below.

<Test Example 3>

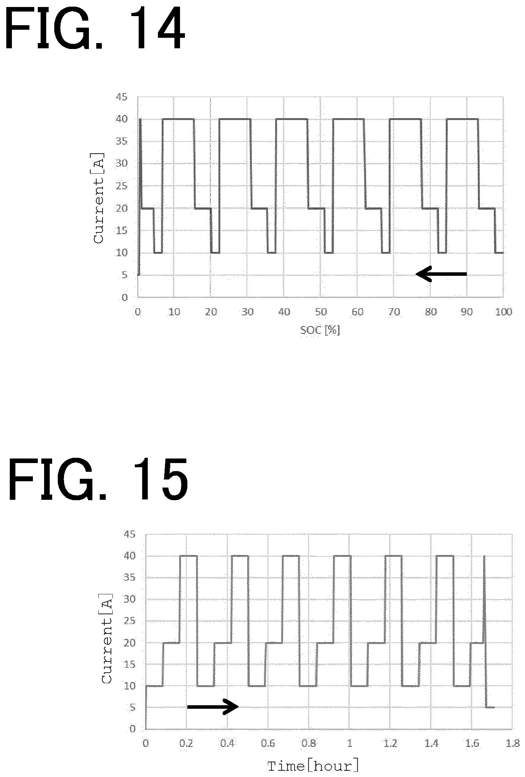

As shown in Table 2 below, the secondary battery unit 2 was discharged, under the conditions: execution temperature 10°C and SOH=87.6%, until the actual state of charge finally reached (actual final SOC) became 0%. Figs. 14 and 15 are graphs illustrating changes in the current value of the secondary battery unit 2 during this period. In Fig. 14, the current value changes from the right side toward the left side as indicated by an arrow in the drawing.

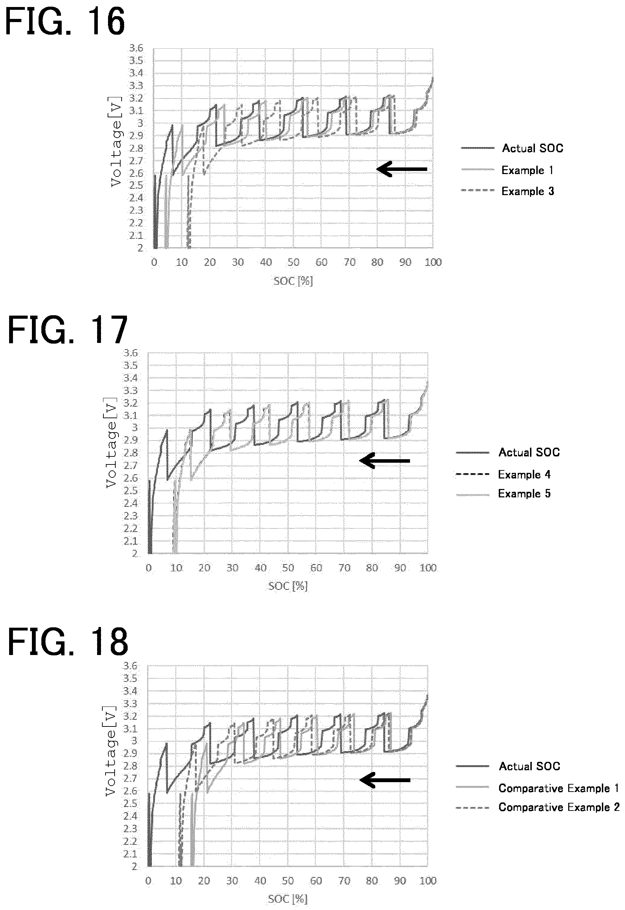

During the discharging of the secondary battery unit 2, the corrected full charge capacity $FCC_{adj}$ of the secondary battery unit 2 was calculated in the state of charge estimation device. Using the corrected full charge capacity $FCC_{adj}$, the state of charge of the secondary battery unit 2 was estimated (calculated). Figs. 16 to 18 are graphs illustrating the actual state of charge (actual SOC) of the secondary battery unit during discharging, the state of charge estimated in each of Examples 1, 3 to 5 and Comparative Examples 1 and 2, and changes in the voltage of the secondary battery unit. In Figs. 16 to 18, the voltage value changes from the right side toward the left side as indicated by an arrow in the drawing. Also, as one of the test results, the finally arrived state of charge (final SOC), the state of charge after discharging, is shown in Table 3 below.

<Test Example 4>

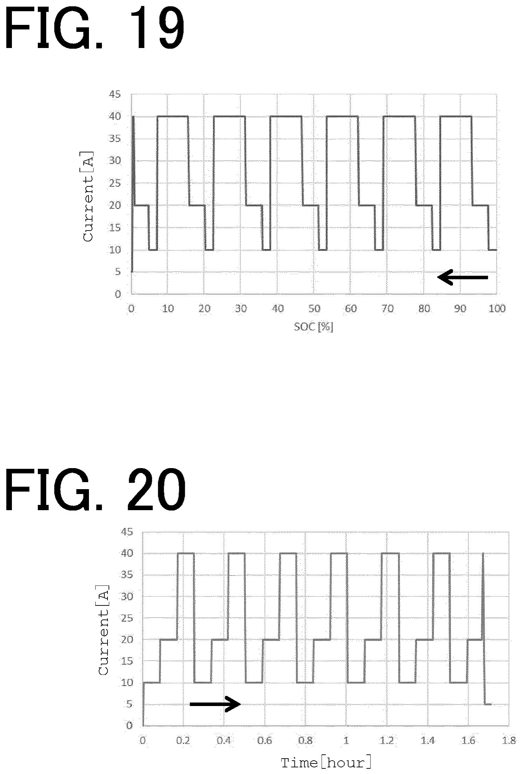

As shown in Table 2 below, the secondary battery unit 2 was discharged, under the conditions: execution temperature 20°C and SOH=87.6%, until the actual state of charge finally reached (actual final SOC) became 0%. Figs. 19 and 20 are graphs illustrating changes in the current value of the secondary battery unit 2 during this period. In Fig. 19, the current value changes from the right side toward the left side as indicated by an arrow in the drawing.

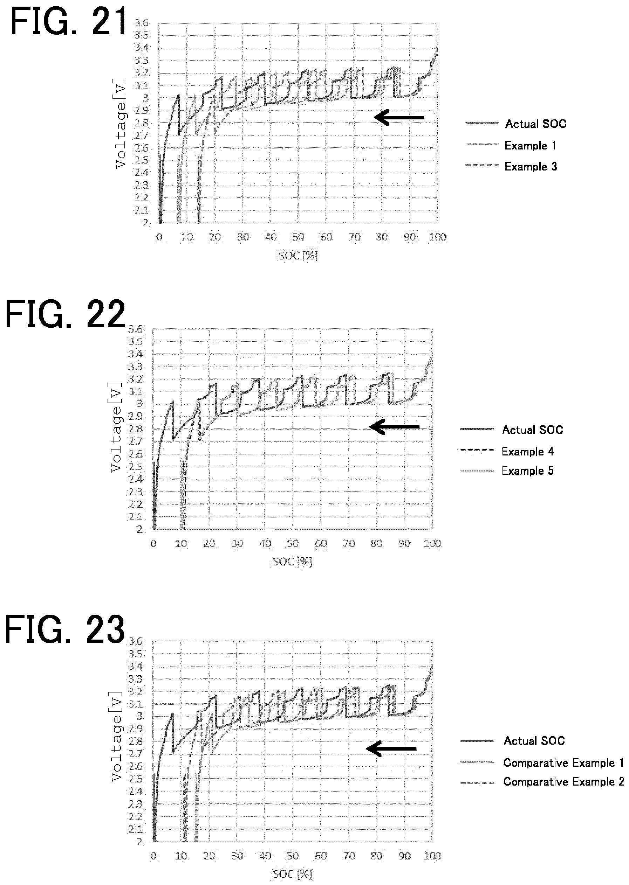

During the discharging of the secondary battery unit 2, the corrected full charge capacity $FCC_{adj}$ of the secondary battery unit 2 was calculated in the state of charge estimation device. Using the corrected full charge capacity $FCC_{adj}$, the state of charge of the secondary battery unit 2 was estimated (calculated). Figs. 21 to 23 are graphs illustrating the actual state of charge (actual SOC) of the secondary battery unit during discharging, the state of charge estimated in each of Examples 1, 3 to 5 and Comparative Examples 1 and 2, and changes in the voltage of the secondary battery unit. In these Figs. 21 to 23, the voltage value changes from the right side toward the left side as indicated by an arrow in the drawing. As one of the test results, the finally arrived state of charge (final SOC), the state of charge after discharging, is shown in Table 3 below.

[Table 2]

| | Test conditions | | | |
|---|---|---|---|---|
| | Test Ex. 1 | Test Ex. 2 | Test Ex. 3 | Test Ex. 4 |
| Charging/discharging | charging | charging | discharging | discharging |
| Execution temp.(°C) | 10 | 20 | 10 | 20 |
| SOH(%) | 87.6 | 87.6 | 87.6 | 87.6 |
| Actual final SOC(%) | 100 | 100 | 0 | 0 |

[Table 3]

| | Final SOC(%) | | | |
|---|---|---|---|---|
| | Test Ex. 1 | Test Ex. 2 | Test Ex. 3 | Test Ex. 4 |
| Ex. 1 | 92.3 | 90.6 | 4.0 | 6.7 |
| Ex. 2 | 90.5 | 90.8 | 5.9 | 6.6 |
| Ex. 3 | 84.6 | 83.7 | 12.1 | 13.9 |
| Ex. 4 | 89.3 | 87.8 | 9.1 | 10.3 |
| Ex. 5 | 89.9 | 88.8 | 9.1 | 10.0 |
| Ex. 6 | 89.1 | 87.0 | 8.3 | 10.6 |
| Ex. 7 | 86.9 | 87.5 | 10.6 | 10.3 |
| Ex. 8 | 88.8 | 88.7 | 10.2 | 10.0 |
| Ex. 9 | 88.2 | 88.7 | 9.1 | 10.0 |
| Ex. 10 | 89.9 | 91.5 | 6.9 | 6.6 |
| Ex. 11 | 85.8 | 86.1 | 12.7 | 12.4 |
| Ex. 12 | 92.8 | 91.4 | 10.2 | 10.1 |
| Comp.Ex. 1 | 83.6 | 83.7 | 15.4 | 15.1 |
| Comp.Ex. 2 | 116.8 | 108.9 | 11.2 | 11.0 |

As shown in Table 3, in Test Examples 1 to 4, the values of the finally arrived state of charge in Examples 1 to 12 were all close to the value of the actual state of charge finally reached, in comparison with the value of the finally arrived state of charge in Comparative Example 1 using the fixed value as the full charge capacity. In Examples 1 to 12, therefore, the state of charge of the secondary battery unit 2 could be estimated (calculated) with higher accuracy than the accuracy in Comparative Example 1. In addition, in Examples 1 to 12, the value of the full charge capacity of the secondary battery unit 2 used for the calculation of the state of charge could be estimated with higher accuracy than in Comparative Example 1.

Furthermore, the values of the finally arrived state of charge in Examples 1 to 12 were comparable to the finally arrived state of charge in Comparative Example 2 in which the full charge capacity was estimated (calculated) based on the map, or rather were close to the actual finally arrived state of charge. In Examples 1 to 12, therefore, the full charge capacity and the state of charge could be estimated (calculated) with accuracy comparable to or higher than in Comparative Example 2.

When the map is used as in Comparative Example 2, the errors between the estimated values of the full charge capacity and the state of charge and the actual values of the full charge capacity and the state of charge can be reduced by increasing the number of data. However, data storage capacity needs to be increased, and a disadvantage arises such that the calculation of the full charge capacity or the like takes time.

With the present invention, as described above, the Weibull function taking, as the variable, at least one of the indices based on the respective parameters, the charge/discharge current value $i_j$ of the secondary battery unit 2 at the time of measurement, the unit temperature $Temp_j$ at the time of measurement, and the state of health $SOH_j$, at the time of measurement, of the secondary battery unit 2 is used to calculate the corrected full charge capacity, and the state or charge is estimated using this corrected full charge capacity. By so doing, the estimation accuracy for the corrected full charge capacity of the secondary battery unit 2 can be improved. Using the corrected full charge capacity to estimate the state of charge of the secondary battery unit 2, moreover, the estimation accuracy for the state of charge can also be enhanced.

With the present invention, moreover, the physical quantities obtained by the measurements are used, whereby the state of charge can be estimated with high accuracy. Thus, it is possible to estimate the state of charge in real time with good followability. Besides, it is not necessary to render a lot of tables of correction factors, correction maps, etc. ready for use, and a small quantity of data is sufficient. Even a moving body carrying the secondary battery unit, a complex system, or the like is easily integrated into the system.

In a situation under which the state of charge of the secondary battery unit 2 is relatively low and electric power load is high, for example, an error between the actual value and the estimated value of the state of charge of the secondary battery unit 2 tends to arise. Even in such a situation, however, the present invention can obtain the state of charge of the secondary battery unit 2 with a relatively high accuracy.

The present invention has been described with reference to its embodiment above. However, the invention is in no way limited to this embodiment.

In the above-described embodiment, for example, examples for calculating the first correction factor with the use of the formulae (7) to (16). However, these formulae are nothing but examples, and formulas for use in the calculation of the first correction factor are not limited thereto. As stated earlier, the first correction factor may be calculated using the first function, including the Weibull function using, as the variable, at least one of the first index, the second index, the third index, and the fourth index, for the set capacity of the secondary battery unit.

[Explanations of Letters or Numerals]

30 ... Inverter, 31 ... First switch, 32 ... Second switch, 33 ... Third switch, 34 ... Fourth switch, 35 ... Fifth switch, 40 ... Control unit, 41 ... Power generator monitoring unit, 42 ... Storage battery monitoring unit, 43 ... Charge/discharge control unit, 50 ... Junction, 100 ... State of charge estimation unit, 110 ... Corrected full charge capacity estimation unit, 111 ... Current value acquisition means, 112 ... Unit temperature acquisition means, 113 ... State of health acquisition means, 115 ... Corrected full charge capacity calculation means

**Claims**

1. A secondary battery unit charging state estimation device which estimates, by employing the following formula 1 or 2, a state of charge (SOC) or a state of power (SOP) of a secondary battery unit having at least one battery cell, wherein

   the secondary battery unit charging state estimation device is equipped with a corrected full charge capacity calculation means for calculating a corrected full charge capacity ($FCC_{adj}$) of the secondary battery unit; and
   the corrected full charge capacity calculation means calculates the corrected full charge capacity ($FCC_{adj}$) by employing a Weibull function which uses, as variables, indices based on physical quantities at the time of measurement which are obtained from the secondary battery unit:
   [Equation 1]

$$SOC = SOC_{last} + \sum_{k=1}^{n} \frac{i_k(t_k - t_{k-1})}{FCC_{adj}} \qquad (1)$$

   [Equation 2]

$$SOP = SOP_{last} + \sum_{k=1}^{n} \frac{p_k(t_k - t_{k-1})}{FCC_{adj}} \qquad (2)$$

   where

   $i_k$: Charge/discharge current of the secondary battery unit, representing a current value of the charge/-discharge current being measured,
   $p_k$: Input/output power of the secondary battery unit, representing a power value of the input/output power,

and

$t_k$: Usage time of the secondary battery unit.

2. The secondary battery unit charging state estimation device according to Claim 1, wherein

the corrected full charge capacity calculation means has a first correction factor calculation means;
the first correction factor calculation means calculates a first correction factor which is obtained from a first function, including a Weibull function, using as a variable at least one of the following four indices; and
the corrected full charge capacity calculation means corrects an initial full charge capacity (FCC) by use of the first correction factor to calculate the corrected full charge capacity (FCC$_{adj}$):

First index: First index (I) based on a current value ($i_j$) of the charge/discharge current of the secondary battery unit which is the charge/discharge current at the time of measurement,
Second index: Second index (P) based on a power value ($p_j$) of the input/output power of the secondary battery unit which is the input/output power at the time of measurement,
Third index: Third index (T) based on a temperature (Temp$_j$), at the time of measurement, of the secondary battery unit, and
Fourth index: Fourth index (S) based on a state of health (SOH$_j$), at the time of measurement, of the secondary battery unit.

3. The secondary battery unit charging state estimation device according to Claim 2, wherein

the corrected full charge capacity calculation means
selects a plurality of any functions from among the Weibull function using the first index (I) or the second index (P) as the variable, the Weibull function using the third index (T) as the variable, and the Weibull function using the fourth index (S) as the variable; and
performs predetermined four arithmetic operations of the plurality of functions to calculate the first correction factor.

4. The secondary battery unit charging state estimation device according to Claim 1, wherein

the corrected full charge capacity calculation means has a second correction factor calculation means;
the second correction factor calculation means calculates a second correction factor which is obtained from the Weibull function using as the variable an index (T) based on a temperature, at the time of measurement, of the secondary battery unit; and
the corrected full charge capacity calculation means corrects an initial full charge capacity (FCC) by use of the second correction factor to calculate the corrected full charge capacity (FCC$_{adj}$).

5. The secondary battery unit charging state estimation device according to Claim 4, wherein
the second correction factor calculation means calculates the second correction factor to be obtained from the following formula 3 which uses, as the variables, a temperature (Temp$_j$), at the time of measurement, of the secondary battery unit, and coefficients provided beforehand which are derived from a relationship between a temperature of the secondary battery unit and an initial battery capacity of the battery unit:
[Equation 3]

$$\text{Second correction factor} = \exp\left\{-\left(Temp_j / \eta_{std\_T}\right)^{m_{std\_T}}\right\} \quad (3)$$

where
$\eta_{std\_T}$, $m_{std\_T}$: Coefficients derived from the relationship between the temperature of the secondary battery unit and the initial battery capacity of the battery unit

6. The secondary battery unit charging state estimation device according to Claim 2, wherein

the corrected full charge capacity calculation means has the first correction factor calculation means and a second correction factor calculation means;
the second correction factor calculation means calculates a second correction factor to be obtained from the Weibull function which uses, as the variable, the temperature (Temp$_j$), at the time of measurement, of the secondary battery unit; and

the corrected full charge capacity calculation means corrects the initial full charge capacity (FCC) by use of the first correction factor and the second correction factor to calculate the corrected full charge capacity (FCC$_{adj}$).

7. The secondary battery unit charging state estimation device according to Claim 3, wherein

the corrected full charge capacity calculation means has the first correction factor calculation means and a second correction factor calculation means;

the second correction factor calculation means calculates a second correction factor to be obtained from the Weibull function which uses, as the variable, the temperature (Temp$_j$), at the time of measurement, of the secondary battery unit; and

the corrected full charge capacity calculation means corrects the initial full charge capacity (FCC) by use of the first correction factor and the second correction factor to calculate the corrected full charge capacity (FCC$_{adj}$).

8. The secondary battery unit charging state estimation device according to Claim 7, wherein the second correction factor calculation means calculates the second correction factor to be obtained from the following formula 3 which uses, as the variables, the temperature (Temp$_j$), at the time of measurement, of the secondary battery unit, and coefficients provided beforehand which are derived from a relationship between the temperature of the secondary battery unit and an initial battery capacity of the battery unit:

[Equation 4]

$$\text{Second correction factor} = \exp\left\{-\left(Temp_j/\eta_{std\_T}\right)^{m_{std\_T}}\right\} \quad (3)$$

where

$\eta_{std\_T}$, $m_{std\_T}$: Coefficients provided beforehand which are derived from the relationship between the temperature of the secondary battery unit and the initial battery capacity of the battery unit

9. The secondary battery unit charging state estimation device according to Claim 8, wherein the corrected full charge capacity calculation means corrects the initial full charge capacity (FCC) by use of the first correction factor which is obtained from the following formula 4 and formula 5 to calculate the corrected full charge capacity (FCC$_{adj}$):

[Equation 5]

$$\text{First correction factor} = \exp\left\{-\left(\frac{x(1)}{\eta}\right)^m\right\} \times x(3) \quad (4)$$

[Equation 6]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (5)$$

where

for $x(1)$, $x(2)$ and $\chi(3)$, any indices among the first index (I), the second index (P), the third index (T), and the fourth index (S) are set so as not to overlap, and

the formula 5 is a fitting formula for determining m and $\eta$, and prm(1), prm(2), prm(3), and prm(4) represent any numbers to be obtained by fitting.

10. The secondary battery unit charging state estimation device according to Claim 8, wherein the corrected full charge capacity calculation means corrects the initial full charge capacity (FCC) by use of the first correction factor which is obtained from the following formula 6 and formula 7 to calculate the corrected full charge capacity (FCC$_{adj}$):

[Equation 7]

$$\text{First correction factor} = \exp\left\{-\left(\frac{x(1)}{\eta}\right)^m\right\} \times x(3) \qquad (6)$$

[Equation 8]

$$\begin{bmatrix} m \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (7)$$

where

for $x(1)$, $x(2)$ and $x(3)$, any indices among the first index (I), the second index (P), the third index (T), and the fourth index (S) are set so as not to overlap, and
the formula 7 is a fitting formula for determining m and $\eta$, and prm(1), prm(2), prm(3), and prm(4) represent any numbers to be obtained by fitting.

11. The secondary battery unit charging state estimation device according to Claim 8, wherein
the corrected full charge capacity calculation means corrects the initial full charge capacity (FCC) by use of the first correction factor which is obtained from the following formula 8 and formula 9 to calculate the corrected full charge capacity (FCC$_{adj}$):
[Equation 9]

$$\text{First correction factor} = \exp\left\{-\left(\frac{x(1)}{\eta}\right)^m\right\} \times x(3) \qquad (8)$$

[Equation 10]

$$\begin{bmatrix} \ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (9)$$

where

for $x(1)$, $x(2)$ and $x(3)$, any indices among the first index (I), the second index (P), the third index (T), and the fourth index (S) are set so as not to overlap, and
the formula 9 is a fitting formula for determining m and $\eta$, and prm(1), prm(2), prm(3), and prm(4) represent any numbers to be obtained by fitting.

12. A secondary battery unit charging state estimation method which estimates, by employing the following formula 1 or 2, a state of charge (SOC) or a state of power (SOP) of a secondary battery unit having at least one battery cell, the method comprising:

calculating a corrected full charge capacity (FCC$_{adj}$) of the secondary battery unit; and
calculating the corrected full charge capacity (FCC$_{adj}$) by employing a Weibull function which uses, as variables, indices based on physical quantities at the time of measurement which are obtained from the secondary battery unit:

[Equation 11]

$$SOC = SOC_{last} + \sum_{k=1}^{n} \frac{i_k(t_k - t_{k-1})}{FCC_{adj}} \qquad (1)$$

[Equation 12]

$$SOP = SOP_{last} + \sum_{k=1}^{n} \frac{p_k(t_k - t_{k-1})}{FCC_{adj}} \qquad (2)$$

where

$i_k$: Charge/discharge current of the secondary battery unit, representing a current value of the charge/discharge current being measured,
$p_k$: Input/output power of the secondary battery unit, representing a power value of the input/output power, and
$t_k$: Usage time of the secondary battery unit.

13. The secondary battery unit charging state estimation method according to Claim 12, comprising:

calculating a first correction factor which is obtained from a first function, including a Weibull function, using as a variable at least one of the following four indices; and
correcting an initial full charge capacity (FCC) by use of the first correction factor to calculate the corrected full charge capacity (FCC$_{adj}$):

First index: First index (I) based on a current value ($i_j$) of the charge/discharge current of the secondary battery unit which is the charge/discharge current at the time of measurement,
Second index: Second index (P) based on a power value ($p_j$) of the input/output power of the secondary battery unit which is the input/output power at the time of measurement,
Third index: Third index (T) based on a temperature (Temp$_j$), at the time of measurement, of the secondary battery unit, and
Fourth index: Fourth index (S) based on a state of health (SOH$_j$), at the time of measurement, of the secondary battery unit.

14. The secondary battery unit charging state estimation method according to Claim 13, comprising:

selecting a plurality of any functions from among the Weibull function using the first index (I) or the second index (P) as the variable, the Weibull function using the third index (T) as the variable, and the Weibull function using the fourth index (S) as the variable; and
performing predetermined four arithmetic operations of the plurality of functions to calculate the first correction factor.

15. The secondary battery unit charging state estimation method according to Claim 12, comprising:

calculating a second correction factor which is obtained from the Weibull function using as the variable an index (T) based on a temperature, at the time of measurement, of the secondary battery unit; and
correcting an initial full charge capacity (FCC) by use of the second correction factor to calculate the corrected full charge capacity (FCC$_{adj}$).

16. The secondary battery unit charging state estimation method according to Claim 15, comprising:
calculating the second correction factor to be obtained from the following formula 3 which uses, as the variables, a temperature (Temp$_j$), at the time of measurement, of the secondary battery unit, and coefficients provided beforehand which are derived from a relationship between the temperature of the secondary battery unit and an initial battery capacity of the battery unit:
[Equation 13]

$$\text{Second correction factor} = \exp\left\{-\left(Temp_j/\eta_{std\_T}\right)^{m_{std\_T}}\right\} \qquad (3)$$

where
$\eta_{std\_T}$, $m_{std\_T}$: Coefficients derived from the relationship between the temperature of the secondary battery unit and the initial battery capacity of the battery unit

17. The secondary battery unit charging state estimation method according to Claim 13, comprising:

calculating a second correction factor to be obtained from the Weibull function which uses, as the variable, the temperature ($Temp_j$), at the time of measurement, of the secondary battery unit; and correcting the initial full charge capacity (FCC) by use of the first correction factor and the second correction factor to calculate the corrected full charge capacity ($FCC_{adj}$).

18. The secondary battery unit charging state estimation method according to Claim 14, comprising:

calculating a second correction factor to be obtained from the Weibull function which uses, as the variable, the temperature ($Temp_j$), at the time of measurement, of the secondary battery unit; and correcting the initial full charge capacity (FCC) by use of the first correction factor and the second correction factor to calculate the corrected full charge capacity ($FCC_{adj}$).

19. The secondary battery unit charging state estimation method according to Claim 18, comprising: calculating the second correction factor to be obtained from the following formula 3 which uses, as the variables, the temperature ($Temp_j$), at the time of measurement, of the secondary battery unit, and coefficients provided beforehand which are derived from a relationship between the temperature of the secondary battery unit and an initial battery capacity of the battery unit:
[Equation 14]

$$\text{Second correction factor} = \exp\left\{-\left(Temp_j/\eta_{std\_T}\right)^{m_{std\_T}}\right\} \quad (3)$$

where
$\eta_{std\_T}$, $m_{std\_T}$: Coefficients provided beforehand which are derived from the relationship between the temperature of the secondary battery unit and the initial battery capacity of the battery unit

20. The secondary battery unit charging state estimation method according to Claim 19, comprising: correcting the initial full charge capacity (FCC) by use of the first correction factor which is obtained from the following formula 4 and formula 5 to calculate the corrected full charge capacity ($FCC_{adj}$):
[Equation 15]

$$\text{First correction factor} = \exp\left\{-\left(\frac{x(1)}{\eta}\right)^{m}\right\} \times x(3) \quad (4)$$

[Equation 16]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (5)$$

where

for $x(1)$, $x(2)$ and $x(3)$, any indices among the first index (I), the second index (P), the third index (T), and the fourth index (S) are set so as not to overlap, and
the formula 5 is a fitting formula for determining m and $\eta$, and prm(1), prm(2), prm(3), and prm(4) represent any numbers to be obtained by fitting.

21. The secondary battery unit charging state estimation method according to Claim 19, comprising: correcting the initial full charge capacity (FCC) by use of the first correction factor which is obtained from the following formula 6 and formula 7 to calculate the corrected full charge capacity ($FCC_{adj}$):
[Equation 17]

$$\text{First correction factor} = \exp\left\{-\left(\frac{x(1)}{\eta}\right)^{m}\right\} \times x(3) \quad (6)$$

[Equation 18]

$$\begin{bmatrix} m \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (7)$$

where

for $x(1)$, $x(2)$ and $\chi(3)$, any indices among the first index (I), the second index (P), the third index (T), and the fourth index (S) are set so as not to overlap, and
the formula 7 is a fitting formula for determining m and $\eta$, and prm(1), prm(2), prm(3), and prm(4) represent any numbers to be obtained by fitting.

22. The secondary battery unit charging state estimation method according to Claim 19, comprising:
correcting the initial full charge capacity (FCC) by use of the first correction factor which is obtained from the following formula 8 and formula 9 to calculate the corrected full charge capacity (FCC$_{adj}$):
[Equation 19]

$$\text{First correction factor} = \exp\left\{-\left(\frac{x(1)}{\eta}\right)^{m}\right\} \times x(3) \qquad (8)$$

[Equation 20]

$$\begin{bmatrix} ln\,(m) \\ ln\,(\eta) \end{bmatrix} = \begin{bmatrix} prm(1) \\ prm(3) \end{bmatrix} \times x(2) + \begin{bmatrix} prm(2) \\ prm(4) \end{bmatrix} \qquad (9)$$

where

for $x(1)$, $x(2)$ and $\chi(3)$, any indices among the first index (I), the second index (P), the third index (T), and the fourth index (S) are set so as not to overlap, and
the formula 9 is a fitting formula for determining m and $\eta$, and prm(1), prm(2), prm(3), and prm(4) represent any numbers to be obtained by fitting.

23. A secondary battery unit charging state estimation program which estimates, by employing the following formula 1 or formula 2, a state of charge (SOC) or a state of power (SOP) of a secondary battery unit having at least one battery cell, the program comprising:
making a computer function to execute a procedure of calculating a corrected full charge capacity (FCC$_{adj}$) by employing a Weibull function which uses, as variables, indices based on physical quantities at the time of measurement which are obtained from the secondary battery unit:
[Equation 21]

$$SOC = SOC_{last} + \sum_{k=1}^{n} \frac{i_k(t_k - t_{k-1})}{FCC_{adj}} \qquad (1)$$

[Equation 22]

$$SOP = SOP_{last} + \sum_{k=1}^{n} \frac{p_k(t_k - t_{k-1})}{FCC_{adj}} \qquad (2)$$

where

$i_k$: Charge/discharge current of the secondary battery unit, representing a current value of the charge/discharge current being measured,

$p_k$: Input/output power of the secondary battery unit, representing a power value of the input/output power, and

$t_k$: Usage time of the secondary battery unit.

24. The secondary battery unit charging state estimation program according to Claim 23, comprising making a computer function to execute a procedure of:

calculating a first correction factor which is obtained from a first function, including a Weibull function, using as a variable at least one of the following four indices; and

correcting an initial full charge capacity (FCC) by use of the first correction factor to calculate the corrected full charge capacity ($FCC_{adj}$):

First index: First index (I) based on a current value ($I_j$) of the charge/discharge current of the secondary battery unit which is the charge/discharge current at the time of measurement,

Second index: Second index (P) based on a power value ($P_j$) of the input/output power of the secondary battery unit which is the input and output power at the time of measurement,

Third index: Third index (T) based on a temperature ($Temp_j$), at the time of measurement, of the secondary battery unit, and

Fourth index: Fourth index (S) based on a state of health ($SOH_j$), at the time of measurement, of the secondary battery unit.

25. The secondary battery unit charging state estimation program according to Claim 24, comprising making a computer function to execute a procedure of:

selecting a plurality of any functions from among the Weibull function using the first index (I) or the second index (P) as the variable, the Weibull function using the third index (T) as the variable, and the Weibull function using the fourth index (S) as the variable; and

performing predetermined four arithmetic operations of the plurality of functions to calculate the first correction factor.

26. The secondary battery unit charging state estimation program according to Claim 23, comprising making a computer function to execute a procedure of:

calculating a second correction factor which is obtained from the Weibull function using as the variable an index (T) based on a temperature, at the time of measurement, of the secondary battery unit; and

correcting an initial full charge capacity (FCC) by use of the second correction factor to calculate the corrected full charge capacity ($FCC_{adj}$).

27. The secondary battery unit charging state estimation program according to Claim 26, comprising making a computer function to execute a procedure of:

calculating the second correction factor to be obtained from the following formula 3 which uses, as the variables, a temperature ($Temp_j$), at the time of measurement, of the secondary battery unit, and coefficients provided beforehand which are derived from a relationship between a temperature of the secondary battery unit and an initial battery capacity of the battery unit:

[Equation 23]

$$\text{Second correction factor} = \exp\left\{-\left(Temp_j/\eta_{std\_T}\right)^{m_{std\_T}}\right\} \quad (3)$$

where

$\eta_{std\_T}$, $m_{std\_T}$: Coefficients derived from the relationship between the temperature of the secondary battery unit and the initial battery capacity of the battery unit.

28. The secondary battery unit charging state estimation program according to Claim 24, comprising making a computer function to execute a procedure of:

calculating a second correction factor to be obtained from the Weibull function which uses, as the variable, the temperature ($Temp_j$), at the time of measurement, of the secondary battery unit; and

correcting the initial full charge capacity (FCC) by use of the first correction factor and the second correction factor to calculate the corrected full charge capacity (FCC_adj).

29. The secondary battery unit charging state estimation program according to Claim 25, comprising making a computer function to execute a procedure of:

calculating a second correction factor to be obtained from the Weibull function which uses, as the variable, the temperature (Temp_j), at the time of measurement, of the secondary battery unit; and
correcting the initial full charge capacity (FCC) by use of the first correction factor and the second correction factor to calculate the corrected full charge capacity (FCC_adj).

30. The secondary battery unit charging state estimation program according to Claim 29, comprising making a computer function to execute a procedure of:
calculating the second correction factor to be obtained from the following formula 3 which uses, as the variables, the temperature (Temp_j), at the time of measurement, of the secondary battery unit, and coefficients provided beforehand which are derived from a relationship between a temperature of the secondary battery unit and an initial battery capacity of the battery unit:
[Equation 24]

$$\text{Second correction factor} = \exp\left\{-\left(Temp_j/\eta_{std\_T}\right)^{m_{std\_T}}\right\} \quad (3)$$

where

$\eta_{std\_T}$, $m_{std\_T}$: Coefficients provided beforehand which are derived from the relationship between the temperature of the secondary battery unit and the initial battery capacity of the battery unit

31. The secondary battery unit charging state estimation program according to Claim 30, comprising making a computer function to execute a procedure of:
correcting the initial full charge capacity (FCC) by use of the first correction factor which is obtained from the following formula 4 and formula 5 to calculate the corrected full charge capacity (FCC_adj):
[Equation 25]

$$\text{First correction factor} = \exp\left\{-\left(\frac{x(1)}{\eta}\right)^{m}\right\} \times x(3) \quad (4)$$

[Equation 26]

$$\begin{bmatrix} m \\ \eta \end{bmatrix} = \begin{bmatrix} prm(1) \\ prm(3) \end{bmatrix} \times x(2) + \begin{bmatrix} prm(2) \\ prm(4) \end{bmatrix} \quad (5)$$

where

for $x(1)$, $x(2)$ and $x(3)$, any indices among the first index (I), the second index (P), the third index (T), and the fourth index (S) are set so as not to overlap, and
the formula 5 is a fitting formula for determining m and $\eta$, and prm(1), prm(2), prm(3), and prm(4) represent any numbers to be obtained by fitting.

32. The secondary battery unit charging state estimation program according to Claim 30, comprising making a computer function to execute a procedure of:
correcting the initial full charge capacity (FCC) by use of the first correction factor which is obtained from the following formula 6 and formula 7 to calculate the corrected full charge capacity (FCC_adj):
[Equation 27]

$$\text{First correction factor} = \exp\left\{-\left(\frac{x(1)}{\eta}\right)^m\right\} \times x(3) \quad (6)$$

[Equation 28]

$$\begin{bmatrix} m \\ ln\ (\eta) \end{bmatrix} = \begin{bmatrix} prm(1) \\ prm(3) \end{bmatrix} \times x(2) + \begin{bmatrix} prm(2) \\ prm(4) \end{bmatrix} \quad (7)$$

where

for $x(1)$, $x(2)$ and $\chi(3)$, any indices among the first index (I), the second index (P), the third index (T), and the fourth index (S) are set so as not to overlap, and
the formula 7 is a fitting formula for determining m and $\eta$, and prm(1), prm(2), prm(3), and prm(4) represent any numbers to be obtained by fitting.

33. The secondary battery unit charging state estimation program according to Claim 30, comprising making a computer function to execute a procedure of:
correcting the initial full charge capacity (FCC) by use of the first correction factor which is obtained from the following formula 8 and formula 9 to calculate the corrected full charge capacity (FCC$_{adj}$):
[Equation 29]

$$\text{First correction factor} = \exp\left\{-\left(\frac{x(1)}{\eta}\right)^m\right\} \times x(3) \quad (8)$$

[Equation 30]

$$\begin{bmatrix} ln\ (m) \\ ln\ (\eta) \end{bmatrix} = \begin{bmatrix} prm(1) \\ prm(3) \end{bmatrix} \times x(2) + \begin{bmatrix} prm(2) \\ prm(4) \end{bmatrix} \quad (9)$$

where

for $x(1)$, $x(2)$ and $\chi(3)$, any indices among the first index (I), the second index (P), the third index (T), and the fourth index (S) are set so as not to overlap, and
the formula 9 is a fitting formula for determining m and $\eta$, and prm(1), prm(2), prm(3), and prm(4) represent any numbers to be obtained by fitting.

# FIG. 1

# FIG. 2

# FIG. 3

# FIG. 4

# FIG. 5

## FIG. 6

Actual SOC
Example 1
Example 3

## FIG. 7

Actual SOC
Example 4
Example 5

## FIG. 8

Actual SOC
Comparative Example 1
Comparative Example 2

# FIG. 9

# FIG. 10

# FIG. 11

# FIG. 12

# FIG. 13

# FIG. 14

# FIG. 15

# FIG. 16

Legend:
- Actual SOC
- Example 1
- Example 3

# FIG. 17

Legend:
- Actual SOC
- Example 4
- Example 5

# FIG. 18

Legend:
- Actual SOC
- Comparative Example 1
- Comparative Example 2

# FIG. 19

# FIG. 20

# FIG. 21

# FIG. 22

# FIG. 23

## INTERNATIONAL SEARCH REPORT

| | |
|---|---|
| International application No. | |
| | **PCT/JP2024/006454** |

| | |
|---|---|
| **A. CLASSIFICATION OF SUBJECT MATTER** | |

*G01R 31/367*(2019.01)i; *G01R 31/3828*(2019.01)i; *G01R 31/387*(2019.01)i; *H01M 10/48*(2006.01)i; *H02J 7/00*(2006.01)i
FI:   G01R31/367; G01R31/387; G01R31/3828; H01M10/48 P; H01M10/48 301; H02J7/00 X

According to International Patent Classification (IPC) or to both national classification and IPC

**B.    FIELDS SEARCHED**

Minimum documentation searched (classification system followed by classification symbols)

G01R31/36-31/396; H01M10/42-10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | 田口義晃; 門脇悟志; 吉川岳, "温度変動に対応した鉄道車両用リチウムイオン電池の劣化予測手法", 鉄道総研報告, February 2022, vol. 36, no. 2, pp. 29-34, https://bunken.rtri.or.jp/doc/fileDown.jsp?RairacID=0001004857, (TAGUCHI, Yoshiaki. KADAWAKI, Satoshi. YOSHIKAWA, Gaku. Degradation Prediction Method for Lithium-Ion Battery for Railway Vehicle Considering Temperature Variation. RTRI report.)<br>in particular, section "2.2 Capacity prediction method (Proposed method)" | 1-2, 4, 12-13, 15, 23-24, 26 |
| A | | 3, 5-11, 14, 16-22, 25, 27-33 |
| Y | 足立修一; 廣田幸嗣; 押上勝憲; 馬場厚志; 丸田一郎; 三原輝儀, バッテリマネジメント工学, 第1版, 東京電機大学出版局, 10 December 2015, pp. 194-196, ISBN: 978-4-501-11720-7, (ADACHI, Shuichi. HIROTA, Yukitsugu. OSHIAGE, Katsunori. BABA, Atsushi. MARUTA, Ichiro. MIHARA, Teruyoshi. Battery Management Systems Engineering. 1st edition. Tokyo Denki University Press.)<br>in particular, section "[4] SOC estimation with a current integration method" | 1-2, 4, 12-13, 15, 23-24, 26 |

[✓] Further documents are listed in the continuation of Box C.        [✓] See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **26 April 2024** | **14 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| --- |
| **PCT/JP2024/006454** |

**C.    DOCUMENTS CONSIDERED TO BE RELEVANT**

| Category* | Citation of document, with indication, where appropriate, of the relevant passages | Relevant to claim No. |
| --- | --- | --- |
| Y | JP 2013-126258 A (DENSO CORPORATION) 24 June 2013 (2013-06-24)<br>paragraph [0058] | 1-2, 4, 12-13,<br>15, 23-24, 26 |
| Y | JP 2001-211507 A (NISSAN MOTOR CO., LTD.) 03 August 2001 (2001-08-03)<br>paragraph [0028] | 1-2, 4, 12-13,<br>15, 23-24, 26 |
| A | 田口義晃; 門脇悟志, "パラメータを可変としたワイブル則によるLIBの温度変動に対応した容量予測法の検討", 第61回電池討論会講演要旨集, 20 November 2020, 3A07, (TAGUCHI, Yoshiaki, KADOWAKI, Satoshi. A study of capacity prediction of lithium-ion battery under the temperature varying circumstance based on Weibull law with variable parameter.), non-official translation (Lecture Abstracts of the 61st Battery Symposium in Japan)<br>entire text | 1-33 |
| A | 杉山秀幸; 原富太郎; 福永孝夫; 河上清源, "ワイブル則による新規寿命予測式", 第59回電池討論会講演要旨集, 26 November 2018, p. 212, (SUGIYAMA, Hideyuki. HARA, Tomitaro. FUKUNAGA, Takao. KAWAKAMI, Kiyomoto. New life prediction formula by Weibull law.), non-official translation (Lecture Abstracts of the 59th Battery Symposium in Japan)<br>entire text | 1-33 |
| P, A | WO 2023/022224 A1 (ELIIY POWER CO., LTD.) 23 February 2023 (2023-02-23)<br>entire text | 1-33 |
| P, A | WO 2023/022225 A1 (ELIIY POWER CO., LTD.) 23 February 2023 (2023-02-23)<br>entire text | 1-33 |

Form PCT/ISA/210 (second sheet) (July 2022)

**INTERNATIONAL SEARCH REPORT**
Information on patent family members

International application No.

**PCT/JP2024/006454**

| Patent document cited in search report | | | Publication date (day/month/year) | Patent family member(s) | Publication date (day/month/year) |
|---|---|---|---|---|---|
| JP | 2013-126258 | A | 24 June 2013 | (Family: none) | |
| JP | 2001-211507 | A | 03 August 2001 | (Family: none) | |
| WO | 2023/022224 | A1 | 23 February 2023 | (Family: none) | |
| WO | 2023/022225 | A1 | 23 February 2023 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2016129212 A